(19)

Europäisches
Patentamt

European
Patent Office

Office européen
des brevets

(11) **EP 4 539 364 A1**

(12) **EUROPEAN PATENT APPLICATION**

published in accordance with Art. 153(4) EPC

(43) Date of publication:
**16.04.2025 Bulletin 2025/16**

(21) Application number: **22948664.2**

(22) Date of filing: **01.07.2022**

(51) International Patent Classification (IPC):
**H04L 1/00** (2006.01)    **H03M 13/13** (2006.01)
**H03M 13/09** (2006.01)

(52) Cooperative Patent Classification (CPC):
**H03M 13/09; H03M 13/13; H04L 1/00**

(86) International application number:
**PCT/CN2022/103274**

(87) International publication number:
**WO 2024/000564 (04.01.2024 Gazette 2024/01)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Huawei Technologies Co., Ltd.
Shenzhen, Guangdong 518129 (CN)**

(72) Inventors:
• **TONG, Jiajie
  Shenzhen, Guangdong 518129 (CN)**

• **WANG, Xianbin
  Shenzhen, Guangdong 518129 (CN)**
• **ZHANG, Huazi
  Shenzhen, Guangdong 518129 (CN)**
• **LI, Rong
  Shenzhen, Guangdong 518129 (CN)**
• **WANG, Jun
  Shenzhen, Guangdong 518129 (CN)**

(74) Representative: **Gill Jennings & Every LLP
The Broadgate Tower
20 Primrose Street
London EC2A 2ES (GB)**

(54) **COMMUNICATION METHOD AND COMMUNICATION APPARATUS**

(57)    This application provides a communication method and a communication apparatus, to reduce implementation complexity of a polar code, so as to improve communication efficiency. In the method, a transmit end obtains to-be-encoded information, where the to-be-encoded information includes k bits, and k is a positive integer; the transmit end determines that a quantity of code blocks is C, and C is a positive integer; the transmit end performs polar encoding on the to-be-encoded information based on C, to obtain C encoded code blocks; and the transmit end sends the C encoded code blocks. In some implementations, the transmit end determines, based on k and a target bit rate, that the quantity of code blocks is C. In some implementations, the transmit end obtains the C encoded code blocks in a code block coupling manner. In some implementations, the transmit end sends the C encoded code blocks based on a first cyclic buffer and a second cyclic buffer.

EP 4 539 364 A1

```
Transmit end                          Receive end

S201: Obtain to-be-encoded information

S202: Determine that a quantity of code
blocks is C

S203: Perform polar encoding on the to-be-
encoded information based on C, to obtain
C encoded code blocks

               S204: Send the C
               encoded code blocks  →  S204: Receive first information

                                         S205: Determine that a quantity of code
                                         blocks corresponding to the first
                                         information is C

                                         S206: Determine, based on C, the C
                                         encoded code blocks corresponding to the
                                         first information

                                         S207: Determine k pieces of bit information
                                         based on the C encoded code blocks
```

FIG. 2

**Description**

**TECHNICAL FIELD**

This application relates to the field of communication technologies, and in particular, to a communication method and a communication apparatus.

**BACKGROUND**

In a communication system, processing procedures in which a transmit end sends information include: channel encoding, modulation, resource mapping, antenna mapping, and the like. A polar (Polar) code is a channel coding scheme that can be strictly proved to "achieve" a Shannon channel capacity. In a 5G standard, it has been determined that the polar code is used as a channel coding scheme of a control channel.

However, how to reduce implementation complexity of the polar code is an urgent technical problem to be resolved.

**SUMMARY**

This application provides a communication method and a communication apparatus, to reduce implementation complexity of a polar code, so as to improve communication efficiency.

A first aspect of this application provides a communication method. The method is performed by a transmit end, or the method is performed by some components (for example, a processor, a chip, or a chip system) in the transmit end, or the method may be implemented by a logical module or software that can implement all or some functions of the transmit end. In the first aspect and possible implementations of the first aspect, an example in which the communication method is performed by the transmit end is used for description. In the method, a transmit end obtains to-be-encoded information, where the to-be-encoded information includes k bits, and k is a positive integer; the transmit end determines that a quantity of code blocks is C, and C is a positive integer; the transmit end performs polar encoding on the to-be-encoded information based on C, to obtain C encoded code blocks; and the transmit end sends the C encoded code blocks.

Based on the foregoing technical solution, in a process of sending information, after the transmit end determines that the quantity of to-be-sent code blocks is C, the transmit end performs polar encoding on the to-be-encoded information based on the quantity C of code blocks, to obtain and send the C encoded code blocks that undergo polar code encoding. Therefore, in an implementation in which the transmit end performs polar code encoding based on the quantity C of code blocks, implementation complexity of the polar code can be reduced, to improve communication efficiency.

It should be understood that after obtaining the C encoded code blocks, the transmit end may further perform at least one operation such as modulation, resource mapping, and antenna mapping on the C encoded code blocks, to obtain and send first information used to carry the C encoded code blocks (or obtain and send first information including the C encoded code blocks), so that a receive end can subsequently obtain the C encoded code blocks based on the received first information.

In a possible implementation of the first aspect, that the transmit end determines that a quantity of code blocks is C includes: The transmit end determines, based on k and a target bit rate, that the quantity of code blocks is C.

Based on the foregoing technical solution, in a process of determining the quantity of code blocks, the transmit end may determine, based on k and the target bit rate, that the quantity of code blocks is C. In other words, the transmit end determines, based on the quantity k of bits of the to-be-encoded information and the target bit rate of polar encoding, that the quantity of polar-encoded code blocks is C. Compared with an implementation process in which the quantity of code blocks is determined based on k, encoding performance may jitter. In the foregoing technical solution, the target bit rate is added as one of bases for determining the quantity of code blocks, so that the encoding performance jitter can be avoided, and encoding performance of polar encoding can be improved.

It should be understood that the quantity k of bits of the to-be-encoded information and the target bit rate meet k/E=R, where E is a target code length, and R is the target bit rate. In other words, any two of three parameters: the quantity of bits of the to-be-encoded information, the target bit rate, and the target code length may be used to determine a value of the other. Therefore, in this implementation, that the quantity of code blocks is determined as C based on k and the target bit rate may also be represented as that the quantity of code blocks is determined as C based on any two of k, the target bit rate, and the target code length.

Optionally, the transmit end determines the target bit rate in a preconfigured manner.

Optionally, the transmit end determines the target bit rate based on an indication (or a configuration) of another device.

In a possible implementation of the first aspect, the target bit rate is one of at least two bit rates.

Based on the foregoing technical solution, the target bit rate is one of at least two bit rates, so that the transmit end may use one of the at least two bit rates as one of bases for determining the quantity of code blocks.

In a possible implementation of the first aspect, the target bit rate is 1/8, 1/4, or 1/2.

Based on the foregoing technical solution, as one of bases used by the transmit end for determining the quantity of code blocks, the target bit rate is 1/8, 1/4, or 1/2 (that is, when the target bit rate is one of the at least two bit rates, the at least two bit rates correspond to three bit rates), so that the transmit end performs a polar code encoding process based on a manner in which the target bit rate is 1/8, 1/4, or 1/2.

Optionally, the at least two bit rates correspond to three bit rates. To be specific, when the transmit end performs polar encoding based on one of the three bit rates, compared with complexity of an implementation in which the transmit end performs polar encoding based on one of more than three bit rates, implementation complexity can be reduced, and the implementation can be applicable to encoding of a low-power polar code, to reduce system power consumption.

In a possible implementation of the first aspect, the determining, based on k and a target bit rate, that the quantity of code blocks is C includes:

when the target bit rate is 1/8 and k is less than a first threshold, determining that C is 1, or

when the target bit rate is 1/8, k is greater than or equal to the first threshold, and k is less than a second threshold, determining that C is 2, or

when the target bit rate is 1/8 and k is greater than or equal to the second threshold, determining that C is 3; or

when the target bit rate is 1/4 and k is less than a third threshold, determining that C is 1, or

when the target bit rate is 1/4, k is greater than or equal to the third threshold, and k is less than a fourth threshold, determining that C is 2, or

when the target bit rate is 1/4 and k is greater than or equal to the fourth threshold, determining that C is 3; or

when the target bit rate is 1/2 and k is less than a fifth threshold, determining that C is 1, or

when the target bit rate is 1/2 and k is greater than or equal to the fifth threshold, determining that C is 2.

Optionally, in the foregoing implementation, when k is equal to a threshold (including any one of the first threshold to the fifth threshold), the transmit end may determine that C is another value.

For example, when the target bit rate is 1/8 and k is equal to the first threshold, it is determined that C is 1.

For another example, when the target bit rate is 1/8 and k is equal to the second threshold, it is determined that C is 2.

For another example, when the target bit rate is 1/4 and k is equal to the third threshold, it is determined that C is 1.

For another example, when the target bit rate is 1/4 and k is equal to the fourth threshold, it is determined that C is 2.

For another example, when the target bit rate is 1/2 and k is equal to the fifth threshold, it is determined that C is 1.

Optionally, the first threshold is greater than or equal to 180 and the first threshold is less than or equal to 205.

Optionally, the second threshold is greater than or equal to 310 and the second threshold is less than or equal to 355.

Optionally, the third threshold is greater than or equal to 175 and the third threshold is less than or equal to 205.

Optionally, the fourth threshold is greater than or equal to 310 and is less than or equal to 335.

Optionally, the fifth threshold is greater than or equal to 290 and the fifth threshold is less than or equal to 310.

In a possible implementation of the first aspect, that the transmit end performs polar encoding on the to-be-encoded information based on C, to obtain C encoded code blocks includes: The transmit end performs polar encoding on the to-be-encoded information based on C, to obtain C initial code blocks; and the transmit end determines the C encoded code blocks based on the C initial code blocks, where an $i^{th}$ encoded code block in the C encoded code blocks is determined based on an $i^{th}$ initial code block in the C initial code blocks, and i is traversed from 1 to C.

Based on the foregoing technical solution, in a process of obtaining the C encoded code blocks, after the transmit end performs polar encoding on the to-be-encoded information based on the quantity C of code blocks to obtain the C initial code blocks, the transmit end determines the C encoded code blocks based on the C initial code blocks. The $i^{th}$ encoded code block in the C encoded code blocks is determined based on the $i^{th}$ initial code block in the C initial code blocks, so that the C encoded code blocks actually sent by the transmit end correspond to the C initial code blocks corresponding to the to-be-encoded information, to reduce processing complexity.

In a possible implementation of the first aspect, that an $i^{th}$ encoded code block in the C encoded code blocks is determined based on an $i^{th}$ initial code block in the C initial code blocks includes: in at least one encoded code block in the C encoded code blocks, the $i^{th}$ encoded code block is the $i^{th}$ initial code block in the C initial code blocks; and in encoded code blocks other than the at least one encoded code block in the C encoded code blocks, x bits in the $i^{th}$ encoded code block are a coupling result of x bits in the $i^{th}$ initial code block in the C initial code blocks and x bits in a $j^{th}$ initial code block, and remaining N-x bits in the $i^{th}$ encoded code block are remaining N-x bits in the $i^{th}$ initial code block in the C initial code blocks. A quantity of the encoded code blocks is a positive integer, x is less than or equal to N, i is not equal to j, both i and j are less than or equal to C, and both i and j are positive integers.

Based on the foregoing technical solution, in the C encoded code blocks, the $i^{th}$ encoded code block in the at least one encoded code block is the same as the $i^{th}$ initial code block in the C initial code blocks. In addition, in the encoded code blocks other than the at least one encoded code block, the x bits in the $i^{th}$ encoded code block are the coupling result of the $i^{th}$ initial code block and the $j^{th}$ initial code block, so that when the x bits in the $i^{th}$ encoded code block are used to transmit information about the x bits in the $i^{th}$ initial code block, the x bits in the $i^{th}$ encoded code block, used as the coupling result, may be further configured to check the $i^{th}$ initial code block and the $j^{th}$ initial code block, to improve information transmission security.

In addition, because the x bits in the $i^{th}$ encoded code block, used as the coupling result, may be further used to check the $i^{th}$ initial code block and the $j^{th}$ initial code block, so that the transmit end does not need to add a cyclic redundancy code (cyclic redundancy code, CRC) check code of a code block (code block, CB) to each encoded code block in the C encoded code blocks, so that check on the code block can be implemented while overheads are reduced, to improve performance.

Optionally, that an $i^{th}$ encoded code block in the C encoded code blocks is determined based on an $i^{th}$ initial code block in the C initial code blocks includes: in the C encoded code blocks, x bits in the $i^{th}$ encoded code block are a coupling result of x bits in the $i^{th}$ initial code block in the C initial code blocks and x bits in a $j^{th}$ initial code block, and remaining N-x bits in the $i^{th}$ encoded code block are remaining N-x bits in the $i^{th}$ initial code block in the C initial code blocks. A quantity of the encoded code blocks is a positive integer, x is less than or equal to N, i is not equal to j, both i and j are less than or equal to C, and both i and j are positive integers. In other words, any code block in the C encoded code blocks is a coupling result of at least two code blocks in the C code blocks.

In a possible implementation of the first aspect, x is equal to N/2.

Based on the foregoing technical solution, quantities of bits corresponding to any code block in the C initial code blocks and the any code block in the C encoded code blocks are N, and the x bits of the $i^{th}$ encoded code block in some or all of the C encoded code blocks are a coupling result. Therefore, in this implementation, when x is equal to N/2, both the x bits in the $i^{th}$ initial code block and the x bits in the $j^{th}$ initial code block that participate in coupling are half of the quantity of bits corresponding to the any code block, that is, information in a buffer can be used through semi-coupling in a ping-pong manner (for example, the x bits in the $j^{th}$ initial code block in the C initial code blocks may be used as the x bits in the $j^{th}$ initial code block in the C encoded code blocks, and the x bits in the $j^{th}$ initial code block in the C initial code blocks may also be used to determine the x bits in the $i^{th}$ initial code block in the C encoded code blocks), so that processing complexity is reduced, and system performance is improved.

Optionally, x may be another value, for example, N/3, N/4, or N/8.

In a possible implementation of the first aspect, the coupling result is an exclusive OR result.

Optionally, the coupling result is an XNOR result, or is another implementation.

In a possible implementation of the first aspect, i=j-1, or i=j+1.

Based on the foregoing technical solution, i=j-1, or i=j+1, that is, the $i^{th}$ initial code block and the $j^{th}$ initial code block that participate in coupling are adjacent code blocks in the C initial code blocks, to reduce processing complexity and improve system performance.

In a possible implementation of the first aspect, that the transmit end sends the C encoded code blocks includes: The transmit end stores a first part of encoded information of the any code block in the C encoded code blocks into a first cyclic buffer, and stores a second part of the encoded information of the any code block in the C encoded code blocks into a second cyclic buffer; the transmit end reads bit information in the first cyclic buffer and bit information in the second cyclic buffer based on a target code length corresponding to the any code block in the C encoded code blocks, and uses the bit information in the first cyclic buffer and the bit information in the second cyclic buffer as a target bit sequence; and the transmit end sends the target bit sequence.

Based on the foregoing technical solution, the transmit end needs to perform rate matching in a process of sending the C encoded code blocks. To be specific, the transmit end stores information based on at least two cyclic buffers (including the first cyclic buffer and the second cyclic buffer), reads, based on a target code length, information stored in the at least two cyclic buffers to obtain and send a target bit sequence, to simplify a rate matching process, reduce complexity, and reduce performance loss.

Optionally, compared with a manner in which sub-block interleaving is performed on an encoded code block by using only one cyclic buffer to perform rate matching, in the foregoing technical solution, in a manner in which the at least two cyclic buffers (including the first cyclic buffer and the second cyclic buffer) are used to store information, a sub-block interleaving process does not need to be performed, so that complexity can be reduced while maintaining high performance.

In a possible implementation of the first aspect, when the target code length corresponding to the any code block in the C encoded code blocks is less than or equal to a bit length corresponding to the any code block, the target bit sequence includes a first sequence and a second sequence, where the first sequence includes data obtained after puncturing processing is performed on data in the first cyclic buffer, and a sequence length of the first sequence is less than or equal to a sequence length of the first part; and the second sequence includes data obtained after puncturing processing is performed on data in the second cyclic buffer, and a sequence length of the second sequence is less than or equal to a sequence length of the second part; or when the target code length corresponding to the any code block in the C encoded code blocks is greater than a bit length corresponding to the any code block, the target bit sequence includes one sequence, where the one sequence includes data obtained after puncturing processing is performed on data in the first cyclic buffer and data obtained after puncturing processing is performed on data in the second cyclic buffer, and a sequence length of the sequence is greater than the bit length corresponding to the any code block.

Based on the foregoing technical solution, the transmit end performs puncturing processing or repetition processing based on the target code length corresponding to the any code block in the C encoded code blocks and the bit length corresponding to the any code block, to implement the rate matching process, and obtain a rate matching gain, so that information sent by the transmit end can match a resource carrying the information.

Optionally, the foregoing technical solution describes a process of implementing rate matching by using the puncturing processing or repetition processing process. The implementation process may also be implemented by using shortening processing. For example, in a high bit rate scenario, rate matching may be implemented through shortening processing. Considering that an application scenario of this embodiment is mainly a low bit rate, a shortening processing process in the low bit rate scenario may affect performance (for example, in a shortening processing manner, a position of a high-reliability bit in a polar code may need to be located for a plurality of times, resulting in poor performance). Therefore, in the foregoing technical solution, rate matching is implemented by using the puncturing processing or repetition processing process.

In a possible implementation of the first aspect, when a value of the target code length corresponding to the any code block in the C encoded code blocks is an even number, a quantity of bits corresponding to the any code block in the C encoded code blocks in the first cyclic buffer is the same as a quantity of bits corresponding to the any code block in the C code blocks in the second cyclic buffer; or when a value of the target code length corresponding to the any code block in the C encoded code blocks is an odd number, a quantity of bits corresponding to the any code block in the C encoded code blocks in the second cyclic buffer is one more than a quantity of bits corresponding to the any code block in the C encoded code blocks in the first cyclic buffer.

Based on the foregoing technical solution, when the value of the target code length corresponding to the any code block in the C encoded code blocks is the even number, the quantity of bits corresponding to the any code block in the C encoded code blocks in the first cyclic buffer is the same as the quantity of bits corresponding to the any code block in the C code blocks in the second cyclic buffer, so that processing complexity can be reduced. Alternatively, when the value of the target code length corresponding to the any code block in the C encoded code blocks is the odd number, the quantity of bits corresponding to the any code block in the C encoded code blocks in the second cyclic buffer is one more than the quantity of bits corresponding to the any code block in the C encoded code blocks in the first cyclic buffer.

Optionally, when the value of the target code length corresponding to the any code block in the C encoded code blocks is the odd number, the quantity of bits corresponding to the any code block in the C encoded code blocks in the second cyclic buffer is one less than the quantity of bits corresponding to the any code block in the C encoded code blocks in the first cyclic buffer.

In a possible implementation of the first aspect, a quantity of bits corresponding to the first part is half of a quantity of bits corresponding to the encoded information of the any code block in the C code blocks; and/or a quantity of bits corresponding to the second part is half of a quantity of bits corresponding to the encoded information of the any code block in the C code blocks.

Based on the foregoing technical solution, the quantity of bits corresponding to the first part (and/or the second part) is half of the quantity of bits corresponding to the encoded information of the any code block in the C code blocks. To be specific, the transmit end stores the information based on the first cyclic buffer and the second cyclic buffer, and separately reads, based on the target code length, the information stored in the first cyclic buffer and the information stored in the second cyclic buffer to obtain the target bit sequence, so as to reduce implementation complexity.

A second aspect of this application provides a communication method. The method is performed by a receive end, or the method is performed by some components (for example, a processor, a chip, or a chip system) in the receive end, or the method may be implemented by a logical module or software that can implement all or some functions of the receive end. In the second aspect and possible implementations of the second aspect, an example in which the communication method is performed by the receive end is used for description. In the method, the receive end receives first information, where the first information is obtained based on k pieces of bit information, and k is a positive integer; the receive end determines that a quantity of code blocks corresponding to the first information is C, where C is a positive integer; the receive end determines, based on C, C encoded code blocks corresponding to the first information; and the receive end determines the k pieces of bit information based on the C encoded code blocks.

Based on the foregoing technical solution, after the receive end determines that the quantity of code blocks corresponding to the first information is C, the receive end determines, based on C, the C encoded code blocks that correspond to the first information and that undergo polar code encoding, and determines, based on the C encoded code blocks, the k pieces of bit information corresponding to the first information. Therefore, in an implementation in which the receive end performs polar code decoding on the first information based on the quantity C of code blocks, implementation complexity of the polar code can be reduced, to improve communication efficiency.

In a possible implementation of the second aspect, that the receive end determines that a quantity of code blocks corresponding to the first information is C includes: The receive end determines, based on k and a target bit rate, that the quantity of code blocks is C.

Based on the foregoing technical solution, in a process of determining the quantity of code blocks, the receive end may determine, based on k and the target bit rate, that the quantity of code blocks is C. In other words, the receive end determines, based on the quantity k of bits of the to-be-encoded information and the target bit rate of polar encoding, that the quantity of polar-encoded code blocks is C. Compared with an implementation process in which the quantity of code blocks is determined based on k, encoding performance may jitter. In the foregoing technical solution, the target bit rate is added as one of bases for determining the quantity of code blocks, so that the encoding performance jitter can be avoided, and encoding performance of polar encoding can be improved.

It should be understood that the quantity k of bits of the to-be-encoded information and the target bit rate meet k/E=R, where E is a target code length, and R is the target bit rate. In other words, any two of three parameters: the quantity of bits of the to-be-encoded information, the target bit rate, and the target code length may be used to determine a value of the other. Therefore, in this implementation, that the quantity of code blocks is determined as C based on k and the target bit rate may also be represented as that the quantity of code blocks is determined as C based on any two of k, the target bit rate, and the target code length.

Optionally, the receive end determines the target bit rate in a preconfigured manner.

Optionally, the receive end determines the target bit rate based on an indication (or a configuration) of another device (for example, a transmit end).

In a possible implementation of the second aspect, the target bit rate is one of at least two bit rates.

Based on the foregoing technical solution, the target bit rate is one of at least two bit rates, so that the transmit end may use one of the at least two bit rates as one of bases for determining the quantity of code blocks.

In a possible implementation of the second aspect, the target bit rate is 1/8, 1/4, or 1/2.

Based on the foregoing technical solution, as one of bases used by the transmit end for determining the quantity of code blocks, the target bit rate is 1/8, 1/4, or 1/2 (that is, when the target bit rate is one of the at least two bit rates, the at least two bit rates correspond to three bit rates), so that the transmit end performs a polar code encoding process based on a manner in which the target bit rate is 1/8, 1/4, or 1/2.

Optionally, the at least two bit rates correspond to three bit rates. To be specific, when the transmit end performs polar encoding based on one of the three bit rates, compared with complexity of an implementation in which the transmit end performs polar encoding based on one of more than three bit rates, implementation complexity can be reduced, and the implementation can be applicable to encoding of a low-power polar code, to reduce system power consumption.

In a possible implementation of the second aspect, the determining, based on k and a target bit rate, that the quantity of code blocks is C includes:

when the target bit rate is 1/8 and k is less than a first threshold, determining that C is 1, or
when the target bit rate is 1/8, k is greater than or equal to the first threshold, and k is less than a second threshold, determining that C is 2, or
when the target bit rate is 1/8 and k is greater than or equal to the second threshold, determining that C is 3; or
when the target bit rate is 1/4 and k is less than a third threshold, determining that C is 1, or
when the target bit rate is 1/4, k is greater than or equal to the third threshold, and k is less than a fourth threshold, determining that C is 2, or
when the target bit rate is 1/4 and k is greater than or equal to the fourth threshold, determining that C is 3; or
when the target bit rate is 1/2 and k is less than a fifth threshold, determining that C is 1, or
when the target bit rate is 1/2 and k is greater than or equal to the fifth threshold, determining that C is 2.

Optionally, in the foregoing implementation, when k is equal to a threshold (including any one of the first threshold to the fifth threshold), the transmit end may determine that C is another value.

For example, when the target bit rate is 1/8 and k is equal to the first threshold, it is determined that C is 1.

For another example, when the target bit rate is 1/8 and k is equal to the second threshold, it is determined that C is 2.

For another example, when the target bit rate is 1/4 and k is equal to the third threshold, it is determined that C is 1.

For another example, when the target bit rate is 1/4 and k is equal to the fourth threshold, it is determined that C is 2.

For another example, when the target bit rate is 1/2 and k is equal to the fifth threshold, it is determined that C is 1.

Optionally, the first threshold is greater than or equal to 180 and the first threshold is less than or equal to 205.

Optionally, the second threshold is greater than or equal to 310 and the second threshold is less than or equal to 355.

Optionally, the third threshold is greater than or equal to 175 and the third threshold is less than or equal to 205.

Optionally, the fourth threshold is greater than or equal to 310 and is less than or equal to 335.

Optionally, the fifth threshold is greater than or equal to 290 and the fifth threshold is less than or equal to 310.

In a possible implementation of the second aspect, that the receive end determines the k pieces of bit information based on the C encoded code blocks includes: The receive end determines C initial code blocks based on the C encoded code blocks, where an $i^{th}$ initial code block in the C initial code blocks is determined based on an $i^{th}$ encoded code block in the C encoded code blocks, and i is traversed from 1 to C; and the receive end performs decoding based on the C initial code blocks to obtain the k pieces of bit information.

Based on the foregoing technical solution, in a process of determining the k pieces of bit information based on the C encoded code blocks, the receive end determines the C initial code blocks based on the C encoded code blocks. The $i^{th}$ initial code block in the C initial code blocks is determined based on the $i^{th}$ encoded code block in the C encoded code blocks, so that the C encoded code blocks actually received by the receive end correspond to the C initial code blocks corresponding to the k pieces of bit information, to reduce processing complexity.

In a possible implementation of the second aspect, that an $i^{th}$ initial code block in the C initial code blocks is determined based on an $i^{th}$ encoded code block in the C encoded code blocks includes: in at least one initial code block in the C initial code blocks, an $i^{th}$ initial code block is the $i^{th}$ encoded code block in the C encoded code blocks; and in initial code blocks other than the at least one initial code block in the C initial code blocks, a coupling result of x bits in the $i^{th}$ initial code block and x bits in a $j^{th}$ initial code block is x bits in the $i^{th}$ encoded code block in the C encoded code blocks, and remaining N-x bits in the $i^{th}$ initial code block are remaining N-x bits in the $i^{th}$ encoded code block in the C encoded code blocks. A quantity of the encoded code blocks is a positive integer, x is less than or equal to N, i is not equal to j, both i and j are less than or equal to C, and both i and j are positive integers.

Based on the foregoing technical solution, in the C initial code blocks, the $i^{th}$ initial code block in the at least one initial code block is the same as the $i^{th}$ encoded code block in the C encoded code blocks. In addition, in the initial code blocks other than the at least one initial code block, the coupling result of the $i^{th}$ initial code block and the $j^{th}$ initial code block is the x bits in the $i^{th}$ encoded code block, so that when the x bits in the $i^{th}$ encoded code block are used to transmit information about the x bits in the $i^{th}$ initial code block, the x bits in the $i^{th}$ encoded code block, used as the coupling result, may be further configured to check the $i^{th}$ initial code block and the $j^{th}$ initial code block, to improve information transmission security.

In addition, because the x bits in the $i^{th}$ encoded code block, used as the coupling result, may be further used to check the $i^{th}$ initial code block and the $j^{th}$ initial code block, so that the transmit end does not need to add a cyclic redundancy code (cyclic redundancy code, CRC) check code of a code block (code block, CB) to each encoded code block in the C encoded code blocks, so that check on the code block can be implemented while overheads are reduced, to improve performance.

Optionally, that an $i^{th}$ initial code block in the C initial code blocks is determined based on an $i^{th}$ encoded code block in the C encoded code blocks includes: in the C initial code blocks, a coupling result of x bits in the $i^{th}$ initial code block and x bits in a $j^{th}$ initial code block is x bits in the $i^{th}$ encoded code block in the C encoded code blocks, and remaining N-x bits in the $i^{th}$ initial code block are remaining N-x bits in the $i^{th}$ encoded code block in the C encoded code blocks. A quantity of code blocks of the remaining encoded code blocks is a positive integer, x is less than or equal to N, i is not equal to j, both i and j are less than or equal to C, and both i and j are positive integers. In other words, any code block in the C encoded code blocks is a coupling result of at least two code blocks in the C code blocks.

In a possible implementation of the second aspect, x is equal to N/2.

Based on the foregoing technical solution, quantities of bits corresponding to any code block in the C initial code blocks and the any code block in the C encoded code blocks are N, and the x bits of the $i^{th}$ encoded code block in some or all of the C encoded code blocks are a coupling result. Therefore, in this implementation, when x is equal to N/2, both the x bits in the $i^{th}$ initial code block and the x bits in the $j^{th}$ initial code block that participate in coupling are half of the quantity of bits corresponding to the any code block, that is, information in a buffer can be used through semi-coupling in a ping-pong manner (for example, the x bits in the $j^{th}$ initial code block in the C initial code blocks may be used as the x bits in the $j^{th}$ initial code block in the C encoded code blocks, and the x bits in the $j^{th}$ initial code block in the C initial code blocks may also be used to determine the x bits in the $i^{th}$ initial code block in the C encoded code blocks), so that processing complexity is reduced, and system performance is improved.

Optionally, x may be another value, for example, N/3, N/4, or N/8.

In a possible implementation of the second aspect, the coupling result is an exclusive OR result.

Optionally, the coupling result is an XNOR result, or is another implementation.

In a possible implementation of the second aspect, i=j-1, or i=j+1.

Based on the foregoing technical solution, i=j-1, or i=j+1, that is, the $i^{th}$ initial code block and the $j^{th}$ initial code block that participate in coupling are adjacent code blocks in the C initial code blocks, to reduce processing complexity and improve system performance.

In a possible implementation of the second aspect, that the receive end determines, based on C, C encoded code blocks corresponding to the first information includes: The receive end determines a target bit sequence corresponding to the first information; the receive end determines, based on a target code length corresponding to any code block in the C encoded code blocks, bit information of the target bit sequence in a first cyclic buffer and bit information of the target bit sequence in a second cyclic buffer; the receive end determines a first part of encoded information of the any code block in the C encoded code blocks based on the bit information of the target bit sequence in the first cyclic buffer, and determines a second part of the encoded information of the any code block in the C encoded code blocks based on the bit information of the target bit sequence in the second cyclic buffer; and the receive end determines the any code block in the C encoded code blocks based on the first part and the second part.

Based on the foregoing technical solution, in a process in which the receive end determines, based on C, the C encoded code blocks corresponding to the first information, the receive end determines information that is separately stored in at least two cyclic buffers (including the first cyclic buffer and the second cyclic buffer) and that is of the target bit sequence corresponding to the first information, and the receive end performs restoration based on the target code length and the information stored in the at least two cyclic buffers to obtain the any code block in the C encoded code blocks, to simplify a rate matching process, thereby reducing performance loss while reducing complexity.

In a possible implementation of the second aspect, when the target code length corresponding to the any code block in the C encoded code blocks is less than or equal to a bit length corresponding to the any code block, the target bit sequence includes a first sequence and a second sequence, where the first sequence includes data obtained after puncturing processing is performed on data in the first cyclic buffer, and a sequence length of the first sequence is less than or equal to a sequence length of the first part; and the second sequence includes data obtained after puncturing processing is performed on data in the second cyclic buffer, and a sequence length of the second sequence is less than or equal to a sequence length of the second part; or when the target code length corresponding to the any code block in the C encoded code blocks is greater than a bit length corresponding to the any code block, the target bit sequence includes one sequence, where the one sequence includes data obtained after puncturing processing is performed on data in the first cyclic buffer and data obtained after puncturing processing is performed on data in the second cyclic buffer, and a sequence length of the sequence is greater than the bit length corresponding to the any code block.

Based on the foregoing technical solution, the receive end performs puncturing processing or repetition processing based on the target code length corresponding to the any code block in the C encoded code blocks and the bit length corresponding to the any code block, to restore the C encoded code blocks corresponding to the target bit information.

In a possible implementation of the second aspect, when a value of the target code length corresponding to the any code block in the C encoded code blocks is an even number, a quantity of bits corresponding to the any code block in the C encoded code blocks in the first cyclic buffer is the same as a quantity of bits corresponding to the any code block in the C code blocks in the second cyclic buffer; or when a value of the target code length corresponding to the any code block in the C encoded code blocks is an odd number, a quantity of bits corresponding to the any code block in the C encoded code blocks in the second cyclic buffer is one more than a quantity of bits corresponding to the any code block in the C encoded code blocks in the first cyclic buffer.

Based on the foregoing technical solution, when the value of the target code length corresponding to the any code block in the C encoded code blocks is the even number, the quantity of bits corresponding to the any code block in the C encoded code blocks in the first cyclic buffer is the same as the quantity of bits corresponding to the any code block in the C code blocks in the second cyclic buffer, so that processing complexity can be reduced. Alternatively, when the value of the target code length corresponding to the any code block in the C encoded code blocks is the odd number, the quantity of bits corresponding to the any code block in the C encoded code blocks in the second cyclic buffer is one more than the quantity of bits corresponding to the any code block in the C encoded code blocks in the first cyclic buffer.

Optionally, when the value of the target code length corresponding to the any code block in the C encoded code blocks is the odd number, the quantity of bits corresponding to the any code block in the C encoded code blocks in the second cyclic buffer is one less than the quantity of bits corresponding to the any code block in the C encoded code blocks in the first cyclic buffer.

In a possible implementation of the second aspect, a quantity of bits corresponding to the first part is half of a quantity of bits corresponding to the encoded information of the any code block in the C code blocks; and/or a quantity of bits corresponding to the second part is half of a quantity of bits corresponding to the encoded information of the any code block in the C code blocks.

Based on the foregoing technical solution, the quantity of bits corresponding to the first part (and/or the second part) is half of the quantity of bits corresponding to the encoded information of the any code block in the C code blocks. To be specific, the transmit end stores the information based on the first cyclic buffer and the second cyclic buffer, and separately reads, based on the target code length, the information stored in the first cyclic buffer and the information stored in the second cyclic buffer to obtain the target bit sequence, so as to reduce implementation complexity.

A third aspect of this application provides a communication apparatus. The apparatus may implement the method in any one of the first aspect or the possible implementations of the first aspect. The apparatus includes a corresponding unit or module configured to perform the method. The unit or module included in the apparatus can be implemented by software and/or hardware. For example, the apparatus may be a receive end, or the apparatus may be a component (for example, a processor, a chip, or a chip system) in the receive end, or the apparatus may be a logical module or software that can implement all or some functions of the receive end.

The apparatus includes a transceiver unit and a processing unit. The processing unit is configured to obtain to-be-encoded information, where the to-be-encoded information includes k bits, and k is a positive integer. The processing unit is further configured to determine that a quantity of code blocks is C, where C is a positive integer. The processing unit is further configured to perform polar encoding on the to-be-encoded information based on C, to obtain C encoded code blocks. The transceiver unit is configured to send the C encoded code blocks.

In a possible implementation of the third aspect, the processing unit is specifically configured to determine, based on k and a target bit rate, that the quantity of code blocks is C.

In a possible implementation of the third aspect, the target bit rate is one of at least two bit rates.

In a possible implementation of the third aspect, the target bit rate is 1/8, 1/4, or 1/2.

In a possible implementation of the third aspect, the processing unit is specifically configured to:

when the target bit rate is 1/8 and k is less than a first threshold, determine that C is 1, or
when the target bit rate is 1/8, k is greater than or equal to the first threshold, and k is less than a second threshold, determine that C is 2, or
when the target bit rate is 1/8 and k is greater than or equal to the second threshold, determine that C is 3; or
when the target bit rate is 1/4 and k is less than a third threshold, determine that C is 1, or
when the target bit rate is 1/4, k is greater than or equal to the third threshold, and k is less than a fourth threshold, determine that C is 2, or
when the target bit rate is 1/4 and k is greater than or equal to the fourth threshold, determine that C is 3; or
when the target bit rate is 1/2 and k is less than a fifth threshold, determine that C is 1, or
when the target bit rate is 1/2 and k is greater than or equal to the fifth threshold, determine that C is 2.

In a possible implementation of the third aspect,

the first threshold is greater than or equal to 180 and the first threshold is less than or equal to 205; or
the second threshold is greater than or equal to 310 and the second threshold is less than or equal to 355; or
the third threshold is greater than or equal to 175, and the third threshold is less than or equal to 205; or
the fourth threshold is greater than or equal to 310, and the fourth threshold is less than or equal to 335; or
the fifth threshold is greater than or equal to 290, and the fifth threshold is less than or equal to 310.

In a possible implementation of the third aspect, the processing unit is specifically configured to: perform polar encoding on the to-be-encoded information based on C, to obtain C initial code blocks; and determine the C encoded code blocks based on the C initial code blocks, where an $i^{th}$ encoded code block in the C encoded code blocks is determined based on an $i^{th}$ initial code block in the C initial code blocks, and i is traversed from 1 to C.

In a possible implementation of the third aspect, that an $i^{th}$ encoded code block in the C encoded code blocks is determined based on an $i^{th}$ initial code block in the C initial code blocks includes: in at least one encoded code block in the C encoded code blocks, the $i^{th}$ encoded code block is the $i^{th}$ initial code block in the C initial code blocks; and in encoded code blocks other than the at least one encoded code block in the C encoded code blocks, x bits in the $i^{th}$ encoded code block are a coupling result of x bits in the $i^{th}$ initial code block in the C initial code blocks and x bits in a $j^{th}$ initial code block, and remaining N-x bits in the $i^{th}$ encoded code block are remaining N-x bits in the $i^{th}$ initial code block in the C initial code blocks. A quantity of the encoded code blocks is a positive integer, x is less than or equal to N, i is not equal to j, both i and j are less than or equal to C, and both i and j are positive integers.

In a possible implementation of the third aspect, x is equal to N/2.

In a possible implementation of the third aspect, the coupling result is an exclusive OR result.

In a possible implementation of the third aspect, i=j-1, or i=j+1.

In a possible implementation of the third aspect, the transceiver unit is specifically configured to: store a first part of encoded information of any code block in the C encoded code blocks into a first cyclic buffer, and store a second part of the encoded information of the any code block in the C encoded code blocks into a second cyclic buffer; read bit information in the first cyclic buffer and bit information in the second cyclic buffer based on a target code length corresponding to the any code block in the C encoded code blocks, and use the bit information in the first cyclic buffer and the bit information in the second cyclic buffer as a target bit sequence; and send the target bit sequence.

In a possible implementation of the third aspect, when the target code length corresponding to the any code block in the C encoded code blocks is less than or equal to a bit length corresponding to the any code block, the target bit sequence includes a first sequence and a second sequence, where the first sequence includes data obtained after puncturing processing is performed on data in the first cyclic buffer, and a sequence length of the first sequence is less than or equal to a sequence length of the first part; and the second sequence includes data obtained after puncturing processing is performed on data in the second cyclic buffer, and a sequence length of the second sequence is less than or equal to a sequence length of the second part; or when the target code length corresponding to the any code block in the C encoded code blocks is greater than a bit length corresponding to the any code block, the target bit sequence includes one sequence, where the one sequence includes data obtained after puncturing processing is performed on data in the first cyclic buffer and data obtained after puncturing processing is performed on data in the second cyclic buffer, and a sequence length of the sequence is greater than the bit length corresponding to the any code block.

In a possible implementation of the third aspect, when a value of the target code length corresponding to the any code block in the C encoded code blocks is an even number, a quantity of bits corresponding to the any code block in the C encoded code blocks in the first cyclic buffer is the same as a quantity of bits corresponding to the any code block in the C code blocks in the second cyclic buffer; or when a value of the target code length corresponding to the any code block in the C encoded code blocks is an odd number, a quantity of bits corresponding to the any code block in the C encoded code blocks in the second cyclic buffer is one more than a quantity of bits corresponding to the any code block in the C encoded code blocks in the first cyclic buffer.

In a possible implementation of the third aspect, a quantity of bits corresponding to the first part is half of a quantity of bits corresponding to the encoded information of the any code block in the C code blocks; and/or a quantity of bits corresponding to the second part is half of a quantity of bits corresponding to the encoded information of the any code block in the C code blocks.

In the third aspect of this embodiment of this application, composition modules of the communication apparatus may be further configured to perform the steps performed in the possible implementations of the first aspect. For details, refer to the first aspect. Details are not described herein again.

A fourth aspect of this application provides a communication apparatus. The apparatus may implement the method in any one of the second aspect or the possible implementations of the second aspect. The apparatus includes a corresponding unit or module configured to perform the method. The unit or module included in the apparatus can be implemented by software and/or hardware. For example, the apparatus may be a transmit end, or the apparatus may be a component (for example, a processor, a chip, or a chip system) in the transmit end, or the apparatus may be a logical module or software that can implement all or some functions of the transmit end.

The apparatus includes a transceiver unit and a processing unit. The transceiver unit is configured to receive first information, where the first information is obtained based on k pieces of bit information, and k is a positive integer. The processing unit is configured to determine that a quantity of code blocks corresponding to the first information is C, where C is a positive integer. The processing unit is further configured to determine, based on C, C encoded code blocks corresponding to the first information. The processing unit is further configured to determine the k pieces of bit information based on the C encoded code blocks.

In a possible implementation of the fourth aspect, the processing unit is specifically configured to determine, based on k and a target bit rate, that the quantity of code blocks is C.

In a possible implementation of the fourth aspect, the target bit rate is one of at least two bit rates.

In a possible implementation of the fourth aspect, the target bit rate is 1/8, 1/4, or 1/2.

In a possible implementation of the fourth aspect, the determining, based on k and a target bit rate, that the quantity of code blocks is C includes:

when the target bit rate is 1/8 and k is less than a first threshold, determining that C is 1, or
when the target bit rate is 1/8, k is greater than or equal to the first threshold, and k is less than a second threshold, determining that C is 2, or
when the target bit rate is 1/8 and k is greater than or equal to the second threshold, determining that C is 3; or
when the target bit rate is 1/4 and k is less than a third threshold, determining that C is 1, or
when the target bit rate is 1/4, k is greater than or equal to the third threshold, and k is less than a fourth threshold, determining that C is 2, or
when the target bit rate is 1/4 and k is greater than or equal to the fourth threshold, determining that C is 3; or
when the target bit rate is 1/2 and k is less than a fifth threshold, determining that C is 1, or
when the target bit rate is 1/2 and k is greater than or equal to the fifth threshold, determining that C is 2.

In a possible implementation of the fourth aspect,

the first threshold is greater than or equal to 180 and the first threshold is less than or equal to 205; or
the second threshold is greater than or equal to 310 and the second threshold is less than or equal to 355; or
the third threshold is greater than or equal to 175, and the third threshold is less than or equal to 205; or

the fourth threshold is greater than or equal to 310, and the fourth threshold is less than or equal to 335; or
the fifth threshold is greater than or equal to 290, and the fifth threshold is less than or equal to 310.

In a possible implementation of the fourth aspect, the processing unit is specifically configured to: determine C initial code blocks based on the C encoded code blocks, where an $i^{th}$ initial code block in the C initial code blocks is determined based on an $i^{th}$ encoded code block in the C encoded code blocks, and i is traversed from 1 to C; and perform decoding based on the C initial code blocks to obtain the k pieces of bit information.

In a possible implementation of the fourth aspect, that an $i^{th}$ initial code block in the C initial code blocks is determined based on an $i^{th}$ encoded code block in the C encoded code blocks includes: in at least one initial code block in the C initial code blocks, an $i^{th}$ initial code block is the $i^{th}$ encoded code block in the C encoded code blocks; and in initial code blocks other than the at least one initial code block in the C initial code blocks, a coupling result of x bits in the $i^{th}$ initial code block and x bits in a $j^{th}$ initial code block is x bits in the $i^{th}$ encoded code block in the C encoded code blocks, and remaining N-x bits in the $i^{th}$ initial code block are remaining N-x bits in the $i^{th}$ encoded code block in the C encoded code blocks. A quantity of the encoded code blocks is a positive integer, x is less than or equal to N, i is not equal to j, both i and j are less than or equal to C, and both i and j are positive integers.

In a possible implementation of the fourth aspect, x is equal to N/2.

In a possible implementation of the fourth aspect, the coupling result is an exclusive OR result.

In a possible implementation of the fourth aspect, i=j-1, or i=j+1.

In a possible implementation of the fourth aspect, the processing unit is specifically configured to: determine a target bit sequence corresponding to the first information; determine, based on a target code length corresponding to any code block in the C encoded code blocks, bit information of the target bit sequence in a first cyclic buffer and bit information of the target bit sequence in a second cyclic buffer; determine a first part of encoded information of the any code block in the C encoded code blocks based on the bit information of the target bit sequence in the first cyclic buffer, and determine a second part of the encoded information of the any code block in the C encoded code blocks based on the bit information of the target bit sequence in the second cyclic buffer; and determine the any code block in the C encoded code blocks based on the first part and the second part.

In a possible implementation of the fourth aspect, when the target code length corresponding to the any code block in the C encoded code blocks is less than or equal to a bit length corresponding to the any code block, the target bit sequence includes a first sequence and a second sequence, where the first sequence includes data obtained after puncturing processing is performed on data in the first cyclic buffer, and a sequence length of the first sequence is less than or equal to a sequence length of the first part; and the second sequence includes data obtained after puncturing processing is performed on data in the second cyclic buffer, and a sequence length of the second sequence is less than or equal to a sequence length of the second part; or when the target code length corresponding to the any code block in the C encoded code blocks is greater than a bit length corresponding to the any code block, the target bit sequence includes one sequence, where the one sequence includes data obtained after puncturing processing is performed on data in the first cyclic buffer and data obtained after puncturing processing is performed on data in the second cyclic buffer, and a sequence length of the sequence is greater than the bit length corresponding to the any code block.

In a possible implementation of the fourth aspect, when a value of the target code length corresponding to the any code block in the C encoded code blocks is an even number, a quantity of bits corresponding to the any code block in the C encoded code blocks in the first cyclic buffer is the same as a quantity of bits corresponding to the any code block in the C code blocks in the second cyclic buffer; or when a value of the target code length corresponding to the any code block in the C encoded code blocks is an odd number, a quantity of bits corresponding to the any code block in the C encoded code blocks in the second cyclic buffer is one more than a quantity of bits corresponding to the any code block in the C encoded code blocks in the first cyclic buffer.

In a possible implementation of the fourth aspect, a quantity of bits corresponding to the first part is half of a quantity of bits corresponding to the encoded information of the any code block in the C code blocks; and/or a quantity of bits corresponding to the second part is half of a quantity of bits corresponding to the encoded information of the any code block in the C code blocks.

In the fourth aspect of this embodiment of this application, composition modules of the communication apparatus may be further configured to perform the steps performed in the possible implementations of the second aspect. For details, refer to the second aspect. Details are not described herein again.

A fifth aspect of an embodiment of this application provides a communication apparatus, including at least one processor, where the at least one processor is coupled to a memory.

The memory is configured to store a program or instructions.

The at least one processor is configured to execute the program or the instructions, to enable the apparatus to implement the method according to any one of the first aspect or the possible implementations of the first aspect, or to enable the apparatus to implement the method according to any one of the second aspect or the possible implementations of the second aspect.

A sixth aspect of an embodiment of this application provides a communication apparatus, including at least one logic circuit and an input/output interface.

The input/output interface is configured to output C encoded code blocks.

The logic circuit is configured to perform the method according to any one of the first aspect or the possible implementations of the first aspect.

A seventh aspect of an embodiment of this application provides a communication apparatus, including at least one logic circuit and an input/output interface, where

The input/output interface is configured to input first information.

The logic circuit is configured to perform the method according to any one of the second aspect or the possible implementations of the second aspect.

An eighth aspect of an embodiment of this application provides a computer-readable storage medium that stores one or more computer-executable instructions. When the computer-executable instructions are executed by a processor, the processor performs the method according to any one of the first aspect or the possible implementations of the first aspect, or the processor performs the method according to any one of the second aspect or the possible implementations of the second aspect.

A ninth aspect of an embodiment of this application provides a computer program product (or referred to as a computer program) that stores one or more computers. When the computer program product is executed by a processor, the processor performs the method according to any one of the first aspect or the possible implementations of the first aspect, or the processor performs the method according to any one of the second aspect or the possible implementations of the second aspect.

A tenth aspect of an embodiment of this application provides a chip system. The chip system includes at least one processor, configured to support a communication apparatus in implementing a function according to any one of the first aspect or the possible implementations of the first aspect, or configured to support a communication apparatus in implementing a function according to any one of the second aspect or the possible implementations of the second aspect.

In a possible design, the chip system may further include a memory. The memory is configured to store program instructions and data that are necessary for the communication apparatus. The chip system may include a chip, or may include a chip and another discrete component. Optionally, the chip system further includes an interface circuit, and the interface circuit provides program instructions and/or data for the at least one processor.

An eleventh aspect of an embodiment of this application provides a communication system. The communication system includes at least one transmit end and at least one receive end, the at least one transmit end is configured to perform the method in any one of the first aspect and the possible implementations of the first aspect, and the at least one receive end is configured to perform the method in any one of the second aspect and the possible implementations of the second aspect.

For example, the communication system includes the communication apparatus in the third aspect and the communication apparatus in the fourth aspect, and/or the communication system includes the communication apparatus in the fifth aspect, and/or the communication system includes the communication apparatus in the sixth aspect and the communication apparatus in the seventh aspect.

For the technical effect brought by any one of the design manners of the third aspect to the eleventh aspect, refer to the technical effect brought by different design manners of the first aspect or the second aspect. Details are not described herein again.

According to the foregoing technical solutions, it can be learned that embodiments of this application have the following advantages:

In some embodiments, in the implementation in which the transmit end performs polar code encoding based on the quantity C of code blocks, implementation complexity of the polar code can be reduced, to improve communication efficiency.

In some embodiments, in the process of determining the quantity of code blocks, the transmit end may determine, based on k and the target bit rate, that the quantity of code blocks is C. In other words, the transmit end determines, based on the quantity k of bits of the to-be-encoded information and the target bit rate of polar encoding, that the quantity of polar-encoded code blocks is C. Compared with the implementation process in which the quantity of code blocks is determined based on k, encoding performance may jitter. In the foregoing technical solution, the target bit rate is added as one of bases for determining the quantity of code blocks, so that the encoding performance jitter can be avoided, and encoding performance of polar encoding can be improved.

In some embodiments, in the process of obtaining the C encoded code blocks, after the transmit end performs polar encoding on the to-be-encoded information based on the quantity C of code blocks to obtain the C initial code blocks, the transmit end determines the C encoded code blocks based on the C initial code blocks. The $i^{th}$ encoded code block in the C encoded code blocks is determined based on the $i^{th}$ initial code block in the C initial code blocks, so that the C encoded code blocks actually sent by the transmit end correspond to the C initial code blocks corresponding to the to-be-encoded information, to reduce processing complexity.

In some embodiments, the transmit end needs to perform rate matching in the process of sending the C encoded code blocks. To be specific, the transmit end stores the information based on the at least two cyclic buffers (including the first cyclic buffer and the second cyclic buffer), reads, based on the target code length, the information stored in the at least two cyclic buffers to obtain and send the target bit sequence, to simplify the rate matching process, reduce complexity, and reduce performance loss.

## BRIEF DESCRIPTION OF DRAWINGS

FIG. 1 is a diagram of a communication system according to an embodiment of this application;
FIG. 2 is a diagram of polar code encoding;
FIG. 3 is a diagram of a communication method according to this application;
FIG. 4 is another diagram of a communication method according to this application;
FIG. 5a is another diagram of a communication method according to this application;
FIG. 5b is another diagram of a communication method according to this application;
FIG. 6a is another diagram of a communication method according to this application;
FIG. 6b is another diagram of a communication method according to this application;
FIG. 6c is another diagram of a communication method according to this application;
FIG. 7 is another diagram of a communication method according to this application;
FIG. 8 is a diagram of a communication apparatus according to this application; and
FIG. 9 is another diagram of a communication apparatus according to this application;
FIG. 10 is another diagram of a communication apparatus according to this application; and
FIG. 11 is another diagram of a communication apparatus according to this application.

## DESCRIPTION OF EMBODIMENTS

The following describes the technical solutions in embodiments of this application with reference to the accompanying drawings in embodiments of this application. It is clear that the described embodiments are merely a part rather than all of embodiments of this application. All other embodiments obtained by a person of ordinary skill in the art based on embodiments of this application without creative efforts shall fall within the protection scope of this application.

First, some terms in embodiments of this application are explained and described, to facilitate understanding of a person skilled in the art.

(1) Terminal device: may be a wireless terminal device that can receive scheduling and indication information of a network device. The wireless terminal device may be a device that provides voice and/or data connectivity for a user, a handheld device with a wireless connection function, or another processing device connected to a wireless modem.

The terminal device may communicate with one or more core networks or the internet through a radio access network (radio access network, RAN). The terminal device may be a mobile terminal device such as a mobile phone (or referred to as a "cellular" phone or a mobile phone (mobile phone)), a computer, and a data card. For example, the terminal device may be a portable, pocket-sized, handheld, computer built-in, or vehicle-mounted mobile apparatus that exchanges a voice and/or data with the radio access network. For example, the wireless terminal device may be a device such as a personal communication service (personal communication service, PCS) phone, a cordless phone, a session initiation protocol (SIP) phone, a wireless local loop (wireless local loop, WLL) station, a personal digital assistant (personal digital assistant, PDA), a tablet computer (Pad), or a computer having a wireless transceiver function. The wireless terminal device may also be referred to as a system, a subscriber unit (subscriber unit), a subscriber station (subscriber station), a mobile station (mobile station, MS), a remote station (remote station), an access point (access point, AP), a remote terminal (remote terminal) device, an access terminal (access terminal) device, a user terminal device (user terminal), a user agent (user agent), a subscriber station (subscriber station, SS), customer premises equipment (customer premises equipment, CPE), a terminal (terminal), user equipment (user equipment, UE), a mobile terminal (mobile terminal, MT), an uncrewed aerial vehicle, or the like. The terminal device may alternatively be a wearable device and a terminal device in a next generation communication system, for example, a terminal device in a 5G communication system or a terminal device in a future evolved public land mobile network (public land mobile network, PLMN).

(2) Network device: The network device may be a device in a wireless network. For example, the network device may be a radio access network (radio access network, RAN) node (or device), or may be referred to as a base station, through which the terminal device accesses the wireless network. Currently, some examples of the RAN device are: a next-generation NodeB (generation NodeB, gNodeB) in a 5G communication system, a transmission reception point (transmission reception point, TRP), an evolved NodeB (evolved NodeB, eNB), a radio network controller (radio network controller, RNC), a NodeB (NodeB, NB), a base station controller (base station controller, BSC), a base transceiver station (base transceiver station, BTS), a home base station (for example, a home evolved NodeB or a home NodeB, HNB), a satellite, an uncrewed aerial vehicle, a baseband unit (baseband unit, BBU), a wireless fidelity (wireless fidelity, Wi-Fi) access point (access point, AP), or the like. In addition, in a network structure, the network device may include a central unit (central unit, CU) node, a distributed unit (distributed unit, DU) node, or a RAN device including a CU node and a DU node.

The network device can send configuration information (for example, carried in a scheduling message and/or an indication message) to the terminal device. The terminal device further performs network configuration based on the configuration information, so that the network configurations of the network device and the terminal device are aligned. Alternatively, through a network configuration preset in the network device and a network configuration preset in the terminal device, the network configurations of the network device and the terminal device are aligned. Specifically, "alignment" means that when there is an interaction message between the network device and the terminal device, the network device and the terminal device have a consistent understanding of a carrier frequency for sending and receiving the interaction message, determining of a type of the interaction message, a meaning of field information carried in the interaction message, or another configuration of the interaction message.

In addition, in another possible case, the network device may be another apparatus providing a wireless communication function for the terminal device. A specific technology and a specific device form that are used by the network device are not limited in embodiments of this application. For ease of description, this is not limited in embodiments of this application.

The network device may further include a core network device. The core network device includes, for example, an access and mobility management function (access and mobility management function, AMF), a user plane function (user plane function, UPF), or a session management function (session management function, SMF).

In embodiments of this application, an apparatus configured to implement a function of the network device may be a network device, or may be an apparatus, for example, a chip system, that can support the network device in implementing the function. The apparatus may be installed in the network device. In the technical solutions provided in embodiments of this application, an example in which the apparatus configured to implement the function of the network device is a network device is used for describing the technical solutions provided in embodiments of this application.

(3) Configuration and preconfiguration: In this application, both the configuration and the preconfiguration are used. The configuration means that a network device such as a base station or a server sends configuration information of some parameters or parameter values to a terminal by using a message or signaling, so that the terminal determines a communication parameter or a transmission resource based on the values or the information. Similar to the configuration, the preconfiguration may be a manner in which a network device such as a base station or a server sends parameter information or a value to a terminal through a communication link or a carrier. Alternatively, the preconfiguration may be a manner in which a corresponding parameter or parameter value may be defined (for example, a value of a parameter is specified in a standard), or a manner in which a related parameter or value is written into a terminal device in advance. This is not limited in this application. Further, these values and parameters may be changed or updated.

(4) In this application, "indicating" may include a direct indication and an indirect indication. When a piece of indication information is described as indicating A, it may be understood that the indication information carries A, directly indicates A, or indirectly indicates A.

In this application, information indicated by the indication information is referred to as to-be-indicated information. In a specific implementation process, the to-be-indicated information is indicated in a plurality of manners, for example, but not limited to, the following manners: The to-be-indicated information is directly indicated, for example, the to-be-indicated information or an index of the to-be-indicated information is indicated. Alternatively, the to-be-indicated information may be indirectly indicated by indicating other information, and there is an association relationship between the other information and the to-be-indicated information. Alternatively, only a part of the to-be-indicated information may be indicated, and the other part of the to-be-indicated information is known or pre-agreed on. For example, specific information may alternatively be indicated by using an arrangement sequence of a plurality of pieces of information that is pre-agreed on (for example, stipulated in a protocol), to reduce indication overheads to some extent.

The to-be-indicated information may be sent as a whole, or may be divided into a plurality of pieces of sub-information for separate sending. In addition, sending periodicities and/or sending occasions of these pieces of sub-information may be the same or may be different. A specific sending method is not limited in this application. The sending periodicities and/or the sending occasions of these pieces of sub-information may be predefined, for example, predefined according to a protocol, or may be configured by a transmit end device by sending configuration information to a receive end device. The configuration information may include, for example, but not limited to, one or a combination of at least two of radio resource control signaling, media access control (media access control, MAC) layer signaling, and physical layer signaling. The radio resource control signaling includes, for example, radio resource control (radio resource control, RRC) signaling. The MAC layer signaling includes, for example, a MAC control element (CE). The physical layer signaling includes, for example, downlink control information (downlink control information, DCI).

(5) Terms "system" and "network" may be used interchangeably in embodiments of this application. "At least one" means one or more, and "a plurality of" means two or more. The term "and/or" describes an association relationship of associated objects, and indicates that three relationships may exist. For example, A and/or B may indicate the following three cases: Only A exists, both A and B exist, and only B exists, where A and B may be singular or plural. The character "/" generally indicates an "or" relationship between the associated objects. At least one of the following items (pieces) or a similar expression thereof indicates any combination of these items, including a single item (piece) or any combination of a plurality of items (pieces). For example, "at least one of A, B, and C" includes A, B, C, AB, AC, BC, or ABC. In addition, unless otherwise specified, ordinal numbers such as "first" and "second" in embodiments of this application are used to distinguish between a plurality of objects, and are not used to limit a sequence, a time sequence, priorities, or importance of the plurality of objects.

This application may be applied to a long term evolution (long term evolution, LTE) system, a new radio (new radio, NR) system, or another communication system. The communication system includes a network device and a terminal device. The network device is used as a configuration information sending entity, and the terminal device is used as a configuration information receiving entity. Specifically, an entity in the communication system sends configuration information to another entity, and sends data to the another entity, or receives data sent by the another entity. The another entity receives the configuration information, and sends data to the configuration information sending entity based on the configuration information, or receives data sent by the configuration information sending entity. This application may be applied to a terminal device in a connected state or an active state (ACTIVE), or may be applied to a terminal device in a non-connected state (INACTIVE) or an idle state (IDLE).

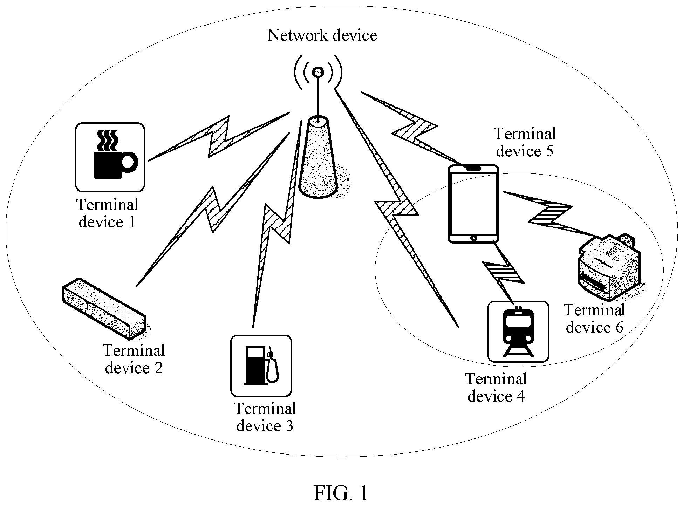

FIG. 1 is a diagram of a communication system according to this application.

FIG. 1 shows an example of a network device and six terminal devices. The six terminal devices are a terminal device 1, a terminal device 2, a terminal device 3, a terminal device 4, a terminal device 5, and a terminal device 6. In the example shown in FIG. 1, an example in which the terminal device 1 is a smart teacup, the terminal device 2 is a smart air conditioner, the terminal device 3 is a smart fuel dispenser, the terminal device 4 is a vehicle, the terminal device 5 is a mobile phone, and the terminal device 6 is a printer is used for description. A transmit end may be a network device or a terminal device, and a receive end may be a network device or a terminal device.

As shown in FIG. 1, in a communication process, a transmit end (or referred to as a transmitting end, a transmission end, or a transmitter device) may be the network device, and a receive end (or referred to as a receiving end, a reception end, or a receiver device) may be the terminal device (for example, the terminal device 1 to the terminal device 6 in FIG. 1); or the transmit end may be the terminal device, and the receive end may be the network device; or both the transmit end and the receive end may be network devices; or both the transmit end and the receive end may be terminal devices.

In a wireless communication process, processing procedures in which the transmit end sends information include: channel encoding, modulation, resource mapping, antenna mapping, and the like. A polar (Polar) code is a channel coding scheme that can be strictly proved to "achieve" a Shannon channel capacity. In a 5G standard, it has been determined that the polar code is used as a channel coding scheme of a control channel.

However, how to reduce implementation complexity of the polar code is an urgent technical problem to be resolved. To resolve the technical problem, the following describes a plurality of embodiments provided in this application with reference to the accompanying drawings.

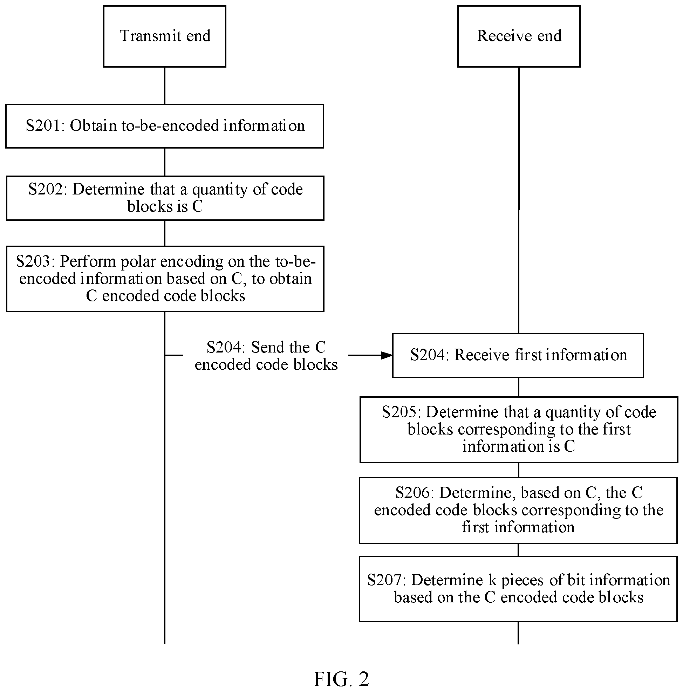

FIG. 2 is a diagram of a communication method according to this application. The method includes the following steps.

S201: A transmit end obtains to-be-encoded information.

In this embodiment, the transmit end obtains the to-be-encoded information in step S201, where the to-be-encoded information includes k bits, and k is a positive integer.

S202: The transmit end determines that a quantity of code blocks is C.

In this embodiment, the transmit end determines, in step S202, that the quantity of code blocks in a polar code encoding process is C, where C is a positive integer.

In a possible implementation, to reduce device power consumption, information transmission is performed by using a fixed code length or a fixed bit rate. The fixed bit rate may be that a transmission bit rate is fixed at two to three types, and the fixed code length may be that all to-be-encoded information is encoded based on the fixed code length and then sent regardless of a quantity of bits corresponding to the to-be-encoded information. For example, an information transmission process performed by using the fixed code length is used as an example. If the quantity of bits corresponding to the to-be-encoded information exceeds the fixed code length, the to-be-encoded information is divided into a plurality of code blocks for sending. If the quantity of bits corresponding to the to-be-encoded information is less than the fixed code length, only one code block needs to be used for sending. To be specific, after some redundant information (or referred to as useless information) is padded, the to-be-encoded information is encoded to the fixed code length for sending. However, in this implementation, selection of the fixed code length (denoted as N) becomes a key point of this solution. If a value of N is large, in some cases, a large quantity of padding bits need to be inserted, thereby wasting communication efficiency. If the value of N is small, the code length is short and performance is poor (for example, because a shorter code length indicates a shorter distance between codewords, performance is poor). In addition, if a quantity of segments is excessively large, overall performance is also affected.

Therefore, in step S202, the transmit end may improve the implementation of information transmission by using the fixed code length or the fixed bit rate. In a possible implementation, in step S202, that the transmit end determines that a quantity of code blocks is C includes: The transmit end determines, based on k and a target bit rate, that the quantity of code blocks is C.

Specifically, in the process of determining the quantity of code blocks, the transmit end may determine, based on k and the target bit rate, that the quantity of code blocks is C. In other words, the transmit end determines, based on the quantity k of bits of the to-be-encoded information and the target bit rate of polar encoding, that the quantity of polar-encoded code blocks is C. Compared with an implementation process in which the quantity of code blocks is determined based on k, encoding performance may jitter. In the foregoing technical solution, the target bit rate is added as one of bases for determining the quantity of code blocks, so that the encoding performance jitter can be avoided, and encoding performance of polar encoding can be improved.

It should be understood that the quantity k of bits of the to-be-encoded information and the target bit rate meet k/E=R, where E is a target code length, and R is the target bit rate. In other words, any two of three parameters: the quantity of bits of the to-be-encoded information, the target bit rate, and the target code length may be used to determine a value of the other. Therefore, in this implementation, that the quantity of code blocks is determined as C based on k and the target bit rate may also be represented as that the quantity of code blocks is determined as C based on any two of k, the target bit rate, and the target code length.

Optionally, the transmit end determines the target bit rate in a preconfigured manner.

Optionally, the transmit end determines the target bit rate based on an indication (or a configuration) of another device.

In a possible implementation, the target bit rate is one of at least two bit rates. Specifically, the target bit rate is one of at least two bit rates, so that the transmit end may use one of the at least two bit rates as one of bases for determining the quantity of code blocks.

In a possible implementation, the target bit rate is 1/8, 1/4, or 1/2. Specifically, as one of bases used by the transmit end for determining the quantity of code blocks, the target bit rate is 1/8, 1/4, or 1/2 (that is, when the target bit rate is one of the at least two bit rates, the at least two bit rates correspond to three bit rates), so that the transmit end performs a polar code encoding process based on a manner in which the target bit rate is 1/8, 1/4, or 1/2.

Optionally, the at least two bit rates correspond to three bit rates. To be specific, when the transmit end performs polar encoding based on one of the three bit rates, compared with complexity of an implementation in which the transmit end performs polar encoding based on one of more than three bit rates, implementation complexity can be reduced, and the implementation can be applicable to encoding of a low-power polar code, to reduce system power consumption.

In a possible implementation, the foregoing process of determining the quantity C of code blocks may be further refined by introducing some thresholds. Specifically, a process in which the transmit end determines, based on k and the target bit rate, that the quantity of code blocks is C may include:

when the target bit rate is 1/8 and k is less than a first threshold, determining that C is 1 (in other words, when the target bit rate is 1/8, the first threshold is an upper limit of one code block into which the to-be-encoded information is grouped), or

when the target bit rate is 1/8, k is greater than or equal to the first threshold, and k is less than a second threshold, determining that C is 2, (in other words, when the target bit rate is 1/8, the first threshold is a lower limit of two code blocks into which the to-be-encoded information is grouped, and when the target bit rate is 1/8, the second threshold is an upper limit of two code blocks into which the to-be-encoded information is grouped), or

when the target bit rate is 1/8 and k is greater than or equal to the second threshold, determining that C is 3 (in other words, when the target bit rate is 1/8, the third threshold is a lower limit of three code blocks into which the to-be-encoded information is grouped); or

when the target bit rate is 1/4 and k is less than a third threshold, determining that C is 1 (in other words, when the target bit rate is 1/4, the third threshold is an upper limit of one code block into which the to-be-encoded information is grouped), or

when the target bit rate is 1/4, k is greater than or equal to the third threshold, and k is less than a fourth threshold, determining that C is 2, (in other words, when the target bit rate is 1/4, the third threshold is a lower limit of two code blocks into which the to-be-encoded information is grouped, and when the target bit rate is 1/4, the fourth threshold is an upper limit of two code blocks into which the to-be-encoded information is grouped), or

when the target bit rate is 1/4 and k is greater than or equal to the fourth threshold, determining that C is 3 (in other words, when the target bit rate is 1/4, the fourth threshold is a lower limit of three code blocks into which the to-be-encoded information is grouped); or

when the target bit rate is 1/2 and k is less than a fifth threshold, determining that C is 1 (in other words, when the target bit rate is 1/2, the fifth threshold is an upper limit of one code block into which the to-be-encoded information is grouped), or

when the target bit rate is 1/2 and k is greater than or equal to the fifth threshold, determining that C is 2 (in other words, when the target bit rate is 1/2, the fifth threshold is a lower limit of two code blocks into which the to-be-encoded information is grouped).

Correspondingly, an information length in each code block meets:

$$K_i = \lfloor K/C \rfloor, \ \text{if}\big(i < mod(K, C)\big) \ K_i = K_i + 1,$$

where

$K_i$ indicates an information length in an $i^{th}$ (i is less than or equal to C) code block, [K/C] indicates that K/C is rounded down, K represents an information length of the to-be-encoded information (that is, a quantity of bits of the to-be-encoded information), C indicates a quantity of code blocks, and Mod (K, C) indicates a remainder of K divided by C. In other words, when K/C cannot be exactly divided, the remainder of K/C is a quantity of remaining unallocated information that is obtained after K subtracts a product of a value, obtained after K/C is rounded down, and C. The remaining unallocated information is allocated to a remainder quantity of Kis, and one more piece of information is allocated to each Ki.

It should be understood that this implementation may also be implemented in the following manner in Table 1. In Table 1, R represents the target bit rate, k represents the quantity k of bits corresponding to the to-be-encoded information, and C represents the quantity of determined code blocks.

**Table 1**

| R target bit rate k c | C=1 | C=2 | C=3 |
|---|---|---|---|
| R=1/8 | K<First threshold | First threshold≤K<Second threshold | K≥Second threshold |
| R=1/4 | K<Third threshold | Third threshold≤K<Fourth threshold | K≥Fourth threshold |
| R=1/2 | K<Fifth threshold | K≥Fifth threshold | |

Optionally, the foregoing implementation is merely an example. When k is equal to a threshold (including any one of the first threshold to the fifth threshold), the transmit end may determine that C is another value.

For example, when the target bit rate is 1/8 and k is equal to the first threshold, it is determined that C is 1.

For another example, when the target bit rate is 1/8 and k is equal to the second threshold, it is determined that C is 2.

For another example, when the target bit rate is 1/4 and k is equal to the third threshold, it is determined that C is 1.

For another example, when the target bit rate is 1/4 and k is equal to the fourth threshold, it is determined that C is 2.

For another example, when the target bit rate is 1/2 and k is equal to the fifth threshold, it is determined that C is 1.

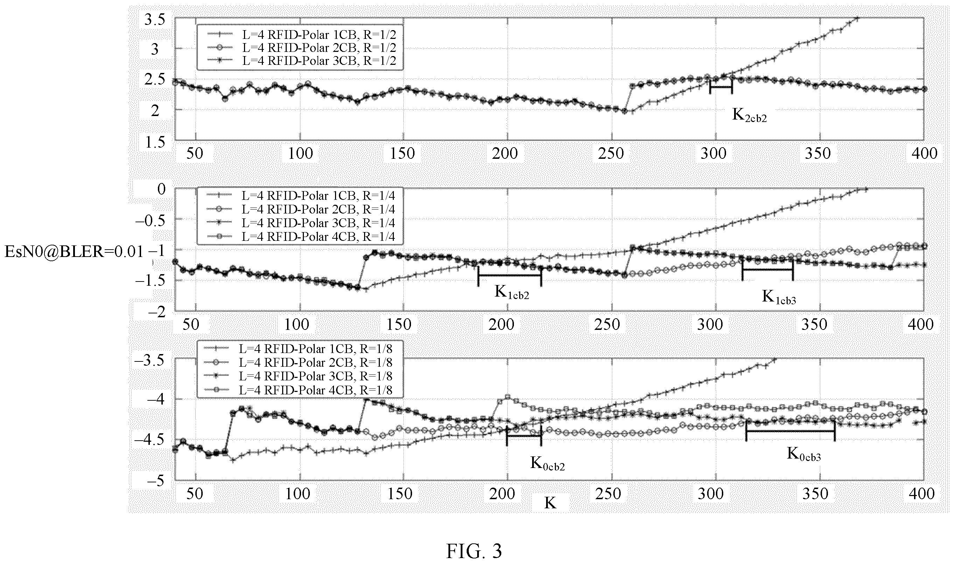

For example, FIG. 3 is a fine-grained simulation result corresponding to different block quantities at three target bit rates (1/8, 1/4, and 1/2). A horizontal coordinate indicates a value of a quantity k of bits corresponding to different to-be-encoded information, and a vertical coordinate indicates a ratio of symbol energy to noise power spectral density (ratio of symbol energy to noise power spectral density, EsN0) required when bler=0.01. A lower vertical coordinate value indicates better performance. As shown in FIG. 3, a line with a plus sign indicates that only one segment is obtained through division. A line with a circle indicates that when a quantity of Es exceeds N, two segments are obtained through division, and a maximum of two segments are obtained through division. A line with an asterisk indicates that when the quantity of Es exceeds N, two segments are obtained through division, and when the quantity of Es exceeds 2*N, three segments are obtained through division, and a maximum of three segments are obtained through division. A line with a rectangle indicates that when the quantity of Es exceeds N, two segments are obtained through division, when the quantity of Es exceeds 2*N, three segments are obtained through division, and when the quantity of Es exceeds 3*N, four segments are obtained through division, and a maximum of four segments are obtained through division.

It can be learned from the simulation result shown in FIG. 3 that the first threshold is greater than or equal to 180 and the first threshold is less than or equal to 205.

Similarly, the second threshold is greater than or equal to 310 and the second threshold is less than or equal to 355.

Similarly, the third threshold is greater than or equal to 175 and the third threshold is less than or equal to 205.

Similarly, the fourth threshold is greater than or equal to 310 and is less than or equal to 335.

Similarly, the fifth threshold is greater than or equal to 290, and the fifth threshold is less than or equal to 310.

Optionally, in addition to the implementation shown in FIG. 3, another simulation method may be used for implementation. In other words, the vertical coordinate may also be implemented through another performance indicator. For example, the vertical coordinate may be BLERs under a same EsN0. A larger BLER under the same EsN0 indicates poorer performance, and a smaller BLER under the same EsN0 indicates better performance.

S203: The transmit end performs polar encoding on the to-be-encoded information based on C, to obtain C encoded code blocks.

In this embodiment, the transmit end performs, based on the quantity C of code blocks determined in step S202, polar encoding on the to-be-encoded information obtained in step S201, to obtain the C encoded code blocks.

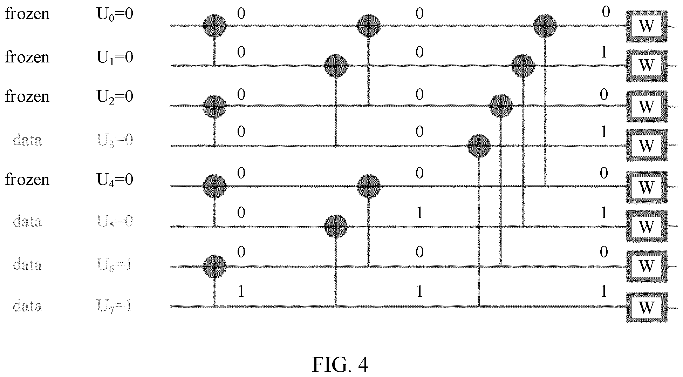

In a possible implementation, FIG. 4 is a diagram of 8X8 polar code encoding (that is, an encoding matrix is an 8*8 matrix) performed by the transmit end. Bits included in the to-be-encoded information are classified into two types based on respective reliability rankings: fixed bits and information bits. The fixed bit is denoted as "frozen (frozen)" in FIG. 4, and the information bit is denoted as "data (data)" in FIG. 4. To-be-encoded bits are ranked based on different reliability of the to-be-encoded bits. Generally, a bit with high reliability is set as the information bit (that is, data), and a bit with low reliability is set as the fixed bit (that is, frozen). A value of the fixed bit is usually set to 0, and is known to both the transmit end and a receive end in actual transmission. In an example shown in FIG. 4, $u_7$, $u_6$, $u_5$, and $u_3$ are four bits whose reliability ranks first, and are set as information bits; and $u_4$, $u_2$, $u_1$, and $u_0$ are four bits whose reliability ranks last, and are set as fixed bits.

Correspondingly, a method in which the receive end subsequently performs polar code decoding is mainly a serial cancellation decoding algorithm. The serial cancellation decoding algorithm means that the receive end performs decoding bit by bit based on a natural time sequence design of the polar code. Currently, the serial cancellation decoding algorithm mainly includes successive cancellation (successive cancellation, SC) decoding, successive cancellation list (successive cancellation list, SCL) decoding, cyclic redundancy code aided successive cancellation list (cyclic redundancy code aided successive cancellation list, CA-SCL) decoding, and the like. It is generally considered that, for decoding performance, SC decoding is poor, SCL decoding is greatly improved compared with SC decoding, and CA-SCL decoding obtained by combining CRC check and SCL decoding can make performance of the polar code better than that of a low-density parity-check code (low-density parity-check code, LDPC) and a turbo code (Turbo code, Turbo code for short). Therefore, currently, SCL decoding and CA-SCL decoding are mainly used in an actual system.

It can be learned from FIG. 4 that a mother code length of the polar code is an integer power of 2. When the code length N required for actual communication is not the mother code length, a code length matching process needs to be further implemented in a manner such as puncturing or retransmission. As the name implies, puncturing or retransmission means that several positions in a mother code length sequence obtained through encoding are removed or retransmitted, so that the mother code length sequence is applicable to a code length requirement. A basic decoding method of the polar code is SC decoding, and SCL decoding is an enhanced implementation on a basis of SC decoding. For example, for SCL, a plurality of possible decoding results are reserved in an SC decoding process, and after decoding is completed, a best possible result is selected from the plurality of possible results as a final decoding result. For another example, if a path metric value is used as a final path selection criterion, basic SCL decoding is implemented. On a basis of SCL decoding, CA-SCL is a further enhanced implementation. Compared with the SCL, an improvement of the CA-SCL lies in that, a CRC value of each decoding result is calculated, and a list with a correct CRC calculation result is selected as a final decoding result. When a code length is short, common SCL may bring a performance gain of 0.5 dB to 1 dB compared with SC, and the CA-SCL may bring an additional 0.5 dB gain. Therefore, CA-SCL decoding is an important decoding manner of the polar code. However, in an implementation process of CA-SCL decoding, a CRC needs to be added to each code block, resulting in high overheads and affecting performance of the polar code.

Therefore, in step S203, the transmit end may further improve the encoding process. In a possible implementation, in step S203, in a process in which the transmit end performs polar encoding on the to-be-encoded information based on C, to obtain C encoded code blocks includes: The transmit end performs polar encoding on the to-be-encoded information based on C, to obtain C initial code blocks; and the transmit end determines the C encoded code blocks based on the C initial code blocks, where an ith encoded code block in the C encoded code blocks is determined based on an ith initial code block in the C initial code blocks, and i is traversed from 1 to C.

Specifically, in the process of obtaining the C encoded code blocks, after the transmit end performs polar encoding on the to-be-encoded information based on the quantity C of code blocks to obtain the C initial code blocks, the transmit end determines the C encoded code blocks based on the C initial code blocks. The ith encoded code block in the C encoded code blocks is determined based on the ith initial code block in the C initial code blocks, so that the C encoded code blocks actually sent by the transmit end correspond to the C initial code blocks corresponding to the to-be-encoded information, to reduce processing complexity.

Optionally, that an ith encoded code block in the C encoded code blocks is determined based on an ith initial code block in the C initial code blocks includes: in at least one encoded code block (that is, a code block that does not participate in coupling) in the C encoded code blocks, the $i^{th}$ encoded code block is the $i^{th}$ initial code block in the C initial code blocks; and in encoded code blocks (that is, code blocks that participate in coupling) in the C encoded code blocks other than the at least one encoded code block, x bits in the $i^{th}$ encoded code block are a coupling result of x bits in the $i^{th}$ initial code block in the C initial code blocks and x bits in a $j^{th}$ initial code block, and remaining N-x bits in the $i^{th}$ encoded code block are remaining N-x bits in the $i^{th}$ initial code block in the C initial code blocks. A quantity of the encoded code blocks is a positive integer, x is less than or equal to N, i is not equal to j, both i and j are less than or equal to C, and both i and j are positive integers.

Specifically, in the C encoded code blocks, the $i^{th}$ encoded code block in the at least one encoded code block is the same as the $i^{th}$ initial code block in the C initial code blocks. In addition, in the encoded code blocks other than the at least one encoded code block, the x bits in the $i^{th}$ encoded code block are the coupling result of the $i^{th}$ initial code block and the $j^{th}$ initial code block, so that when the x bits in the $i^{th}$ encoded code block are used to transmit information about the x bits in the $i^{th}$ initial code block, the x bits in the $i^{th}$ encoded code block, used as the coupling result, may be further configured to check the $i^{th}$ initial code block and the $j^{th}$ initial code block, to improve information transmission security.

In addition, because the x bits in the $i^{th}$ encoded code block, used as the coupling result, may be further used to check the $i^{th}$ initial code block and the $j^{th}$ initial code block, so that the transmit end does not need to add a cyclic redundancy code (cyclic redundancy code, CRC) check code of a code block (code block, CB) to each encoded code block in the C encoded code blocks, so that check on the code block can be implemented while overheads are reduced, to improve performance.

For example, the code block that does not participate in coupling is one code block, and the code block is a first code block in the C initial code blocks. Bit information included in the $i^{th}$ code block in the C initial code blocks may be denoted as $\{c_0^i, c_1^i, c_2^i \ldots c_{N-1}^i\}$.

If i=1, the bit information included in the $i^{th}$ code block in the C encoded code blocks meets:

$$\{d_0^i, d_1^i, d_2^i \ldots d_{N-1}^i\} = \{c_0^i, c_1^i, c_2^i \ldots c_{N-1}^i\}.$$

If i>1, the information about the x bits included in the $i^{th}$ code block in the C encoded code blocks meets:

$$\{d_{N/2+0}^i, d_{N/2+1}^i, d_{N/2+2}^i \ldots d_{N-1}^i\} = \{c_{N/2+0}^i, c_{N/2+1}^i, c_{N/2+2}^i \ldots c_{N-1}^i\}.$$

In addition, the information about the remaining N-x bits included in the $i^{th}$ code block in the C encoded code blocks meets:

$$\{d_0^i, d_1^i, d_2^i \ldots d_{N/2-1}^i\} = \{d_{N/2+0}^{i-1} \wedge c_0^i, d_{N/2+1}^{i-1} \wedge c_1^i, d_{N/2+2}^{i-1} \wedge c_2^i \ldots d_{N-1}^{i-1} \wedge c_{N/2-1}^i\}.$$

Optionally, that an $i^{th}$ encoded code block in the C encoded code blocks is determined based on an $i^{th}$ initial code block in the C initial code blocks includes: in the C encoded code blocks, x bits in the $i^{th}$ encoded code block are a coupling result of x bits in the $i^{th}$ initial code block in the C initial code blocks and x bits in a $j^{th}$ initial code block, and remaining N-x bits in the $i^{th}$ encoded code block are remaining N-x bits in the $i^{th}$ initial code block in the C initial code blocks. A quantity of the encoded code blocks is a positive integer, x is less than or equal to N, i is not equal to j, both i and j are less than or equal to C, and both i and j are positive integers. In other words, any code block in the C encoded code blocks is a coupling result of at least two code blocks in the C code blocks, that is, all the C initial code blocks participate in coupling.

Optionally, in the foregoing implementation process, x is equal to N/2. Specifically, quantities of bits corresponding to any code block in the C initial code blocks and the any code block in the C encoded code blocks are N, and the x bits of the $i^{th}$ encoded code block in some or all of the C encoded code blocks are a coupling result. Therefore, in this implementation, when x is equal to N/2, both the x bits in the $i^{th}$ initial code block and the x bits in the $j^{th}$ initial code block that participate in coupling are half of the quantity of bits corresponding to the any code block, that is, information in a buffer can be used through semi-coupling in a ping-pong manner (for example, the x bits in the $j^{th}$ initial code block in the C initial code blocks may be used as the x bits in the $j^{th}$ initial code block in the C encoded code blocks, and the x bits in the $j^{th}$ initial code block in the C initial code blocks may also be used to determine the x bits in the $i^{th}$ initial code block in the C encoded code blocks), so that processing complexity is reduced, and system performance is improved.

Optionally, in the foregoing implementation process, x may be another value, for example, N (that is, all bit information in the $i^{th}$ initial code block and the $j^{th}$ initial code block participates in coupling, to obtain the $i^{th}$ encoded code block), N/3, N/4, or N/8.

Optionally, in the foregoing implementation process, the coupling result is an exclusive OR result, or the coupling result is an XNOR result, or is another implementation.

Optionally, in the foregoing implementation process, i=j-1, or i=j+1. Specifically, i=j-1, or i=j+1, that is, the $i^{th}$ initial code block and the $j^{th}$ initial code block that participate in coupling are adjacent code blocks in the C initial code blocks, to reduce processing complexity and improve system performance.

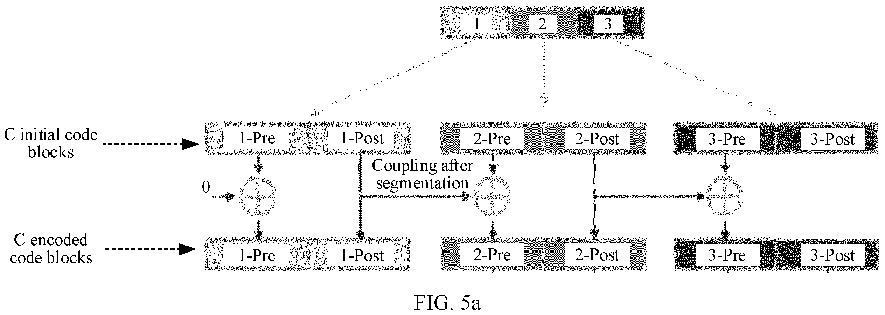

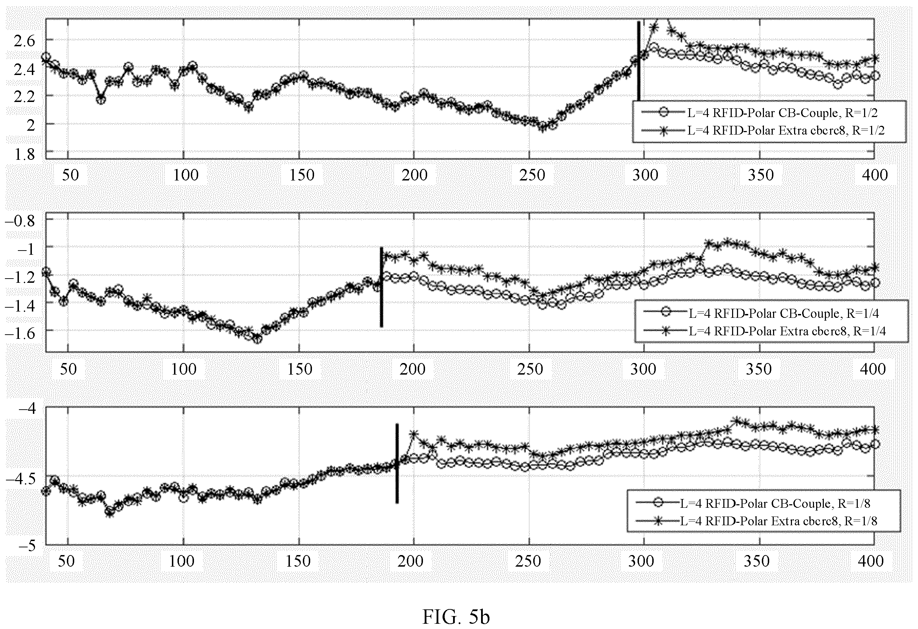

An example in which the quantity C of encoded code blocks is 3 is used below for description with reference to implementation examples in FIG. 5a and FIG. 5b.

As shown in FIG. 5a, the C initial code blocks include a code block 1, a code block 2, and a code block 3. In the C initial code blocks and the C encoded code blocks, each code block 1 includes two parts: "1-Pre" and "1-Post", each code block 2 includes two parts: "2-Pre" and "2-Post", and each code block 3 includes two parts: "3-Pre" and "3-Post". A quantity of bits included in any code block is N, a quantity of bits included in a "Pre" (namely, "1-Pre", "2-Pre", or "3-Pre") part of any code block is "x" mentioned above, and a quantity of bits included in a "Post" (namely, "1-Post", "2-Post", or "3-Post") part of any code block is "N-x" mentioned above.

For example, a quantity of code blocks that do not participate in coupling is 1 (that is, the code block 1), and a quantity of code blocks that participate in coupling is 2 (that is, the code block 2 and the code block 3). To be specific, a first encoded code block does not need to be obtained in a coupling manner; a first half of a second encoded code block is obtained in the coupling manner and a second half of the second encoded code block does not need to be obtained in the coupling manner; and a first half of a third encoded code block is obtained in the coupling manner and a second half of the third encoded code block does not need to be obtained in the coupling manner. Specifically, the following implementation is included.

For the code block 1 that does not participate in coupling in FIG. 5a, the "1-Pre" part of the code block 1 in the C encoded code blocks is the same as the "1-Pre" part of the code block 1 in the C initial code blocks, and the "1-Post" part of the code block 1 in the C encoded code blocks is the same as the "1-Post" part of the code block 1 in the C initial code blocks. Optionally, as shown in FIG. 5a, the "1-Pre" part of the code block 1 in the C encoded code blocks may be a coupling result of the "1-Pre" part of the code block 1 in the C initial code blocks with 0.

For the code block 2 that participates in coupling in FIG. 5a, the "2-Pre" part of the code block 2 in the C encoded code blocks is a coupling result of the "1-Post" part of the code block 1 in the C initial code blocks and the "2-Pre" part of the code block 2 in the C initial code blocks, and the "2-Post" part of the code block 2 in the C encoded code blocks is the same as the "2-Post" part of the code block 2 in the C initial code blocks.

For the code block 3 that participates in coupling in FIG. 5a, the "3-Pre" part of the code block 3 in the C encoded code blocks is a coupling result of the "2-Post" part of the code block 2 in the C initial code blocks and the "3-Pre" part of the code block 3 in the C initial code blocks, and the "3-Post" part of the code block 3 in the C encoded code blocks is the same as the "3-Post" part of the code block 3 in the C initial code blocks.

FIG. 5b is a diagram of a simulation result. A horizontal coordinate indicates different values of K, and a vertical coordinate is an EsN0 required when bler=0.01. A lower value of the vertical coordinate indicates better performance, and segmentation is implemented by using the method described in the embodiment 1. A line with a circle indicates performance of coupling after segmentation, and a line with an asterisk indicates performance of inserting an additional CB-CRC after segmentation. It can be learned from the implementation process shown in FIG. 5b that performance after coupling processing is much better than performance of adding the additional CB-CRC.

S204: The transmit end sends the C encoded code blocks, and correspondingly, the receive end receives first information.

In this embodiment, after the transmit end obtains the C encoded code blocks in step S203, the transmit end sends the C encoded code blocks in step S204, where the C encoded code blocks are used to carry the k bits. Correspondingly, the receive end receives the first information in step S204, where the first information is used to carry the k bits.

It should be understood that after obtaining the C encoded code blocks, the transmit end may further perform at least one operation such as modulation, resource mapping, and antenna mapping on the C encoded code blocks, to obtain and send first information used to carry the C encoded code blocks (or obtain and send first information including the C encoded code blocks), so that a receive end can subsequently obtain the C encoded code blocks based on the received first information.

In a possible implementation, after the transmit end obtains the C encoded code blocks in step S203, the transmit end may perform the sending process in step S204 after performing a rate matching process.

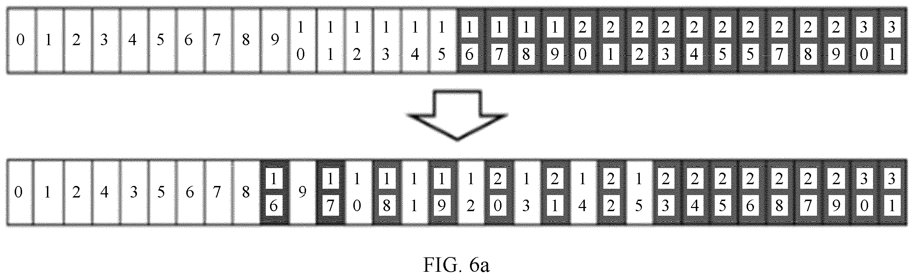

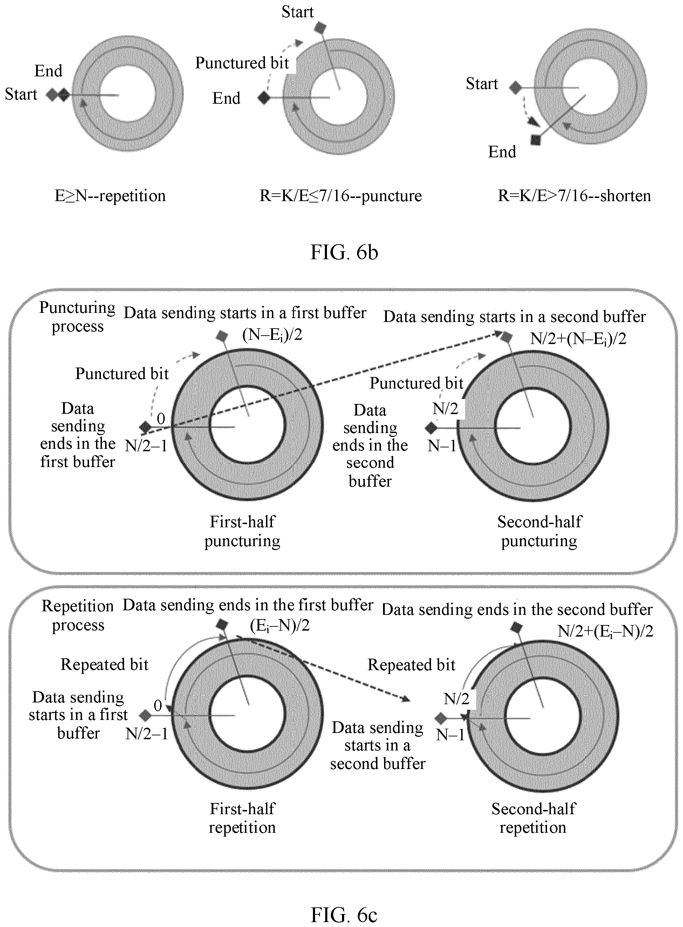

For example, the transmit end may perform the rate matching process based on implementation examples shown in FIG. 6a and FIG. 6b. The transmit end determines a size of a code block (namely, a quantity N of bits corresponding to the code block) in the C encoded code blocks and a size of each actually sent code block (namely, a target code length E, where E=k/R, k is a quantity of bits in the to-be-encoded information, and R is a target bit rate. For details, refer to descriptions in step S201). If N is less than E, a repetition (repetition) processing process is performed. To be specific, the transmit end needs to add some redundant (or useless) bits to any code block in the C encoded code blocks. If N is not less than E, puncturing (Puncture) processing or shortening (Shorten) processing needs to be performed based on a bit rate of the CB. In the puncturing processing or shortening processing process, the transmit end determines positions of Puncture and Shorten based on a difference between a quantity of mother codes and a quantity of CBs and a sequence of sub-block interleaving, and pre-freezes the positions of Puncture and Shorten not to place the information bit. In the puncture mode, in addition to the punctured position, an additional formula is required to determine that more bits are pre-frozen. Therefore, the information bit cannot be placed.

Optionally, after a length of the mother code and the pre-frozen position are determined, all to-be-encoded positions are set as frozen bits, and then a position of the information bit is determined by using a construction sequence. A method is to read a sequence whose length is 1024 from back to front. If a read value is greater than or equal to the mother code or equal to a pre-frozen sequence number, the information bit cannot be placed. Otherwise, a position of the corresponding value is set as the information bit. A quantity of the set information bits is counted. When the quantity is equal to a quantity of information bits that are allocated to the CB, the information bit allocation process is exited, and polar code encoding is performed. In addition, after completing encoding, the transmit end needs to perform sub-block interleaving. A method is to divide the mother code into 32 equal parts, and perform interleaving based on a sequence whose length is 32 (as shown in FIG. 6a). After an interleaving result is output to a cyclic buffer, sending is performed according to Puncture, Shorten, or Repetition (as shown in FIG. 6b).

However, sequence construction and rate matching processes shown in FIG. 6a and FIG. 6b are complex. When sequence construction, encoding, and rate matching are completed based on a current construction algorithm and a hardware architecture, high power consumption is easily caused (for example, when an area is about 10000 square micrometers, power consumption is about 1 mW to 2 mW). In embodiments described below, power consumption may be reduced (for example, when the area is reduced to about 2000 square micrometers, the power consumption is reduced to about 0.1 mW to 0.2 mW).

To reduce power consumption, the implementation process may be improved in step S204. In a possible implementation, in step S204, that the transmit end sends the C encoded code blocks includes: The transmit end stores a first part of encoded information of the any code block in the C encoded code blocks into a first cyclic buffer, and stores a second part of the encoded information of the any code block in the C encoded code blocks into a second cyclic buffer; the transmit end reads bit information in the first cyclic buffer and bit information in the second cyclic buffer based on a target code length corresponding to the any code block in the C encoded code blocks, and uses the bit information in the first cyclic buffer and the bit information in the second cyclic buffer as a target bit sequence; and the transmit end sends the target bit sequence.

Specifically, the transmit end needs to perform rate matching in the process of sending the C encoded code blocks. To be specific, the transmit end stores the information based on the at least two cyclic buffers (including the first cyclic buffer and the second cyclic buffer), reads, based on the target code length, the information stored in the at least two cyclic buffers to obtain and send the target bit sequence, to simplify the rate matching process, reduce complexity, and reduce performance loss.

Optionally, compared with a manner in which sub-block interleaving is performed on an encoded code block by using only one cyclic buffer to perform rate matching, in the foregoing technical solution, in a manner in which the at least two cyclic buffers (including the first cyclic buffer and the second cyclic buffer) are used to store information, a sub-block interleaving process does not need to be performed, so that complexity can be reduced while maintaining high performance.

Optionally, in the foregoing implementation, when the target code length corresponding to the any code block in the C encoded code blocks is less than or equal to a bit length corresponding to the any code block, the target bit sequence includes a first sequence and a second sequence, where the first sequence includes data obtained after puncturing processing is performed on data in the first cyclic buffer, and a sequence length of the first sequence is less than or equal to a sequence length of the first part; and the second sequence includes data obtained after puncturing processing is performed on data in the second cyclic buffer, and a sequence length of the second sequence is less than or equal to a sequence length of the second part; or when the target code length corresponding to the any code block in the C encoded code blocks is greater than a bit length corresponding to the any code block, the target bit sequence includes one sequence, where the one sequence includes data obtained after puncturing processing is performed on data in the first cyclic buffer and data obtained after puncturing processing is performed on data in the second cyclic buffer, and a sequence length of the sequence is greater than the bit length corresponding to the any code block. Specifically, the transmit end performs puncturing processing or repetition processing based on the target code length corresponding to the any code block in the C encoded code blocks and the bit length corresponding to the any code block, to implement rate matching, and obtain a rate matching gain, so that information sent by the transmit end can match a resource carrying the information.

Optionally, the foregoing technical solution describes a process of implementing rate matching by using the puncturing processing or repetition processing process. The implementation process may also be implemented by using shortening processing. For example, in a high bit rate scenario, rate matching may be implemented through shortening processing. Considering that an application scenario of this embodiment is mainly a low bit rate, a shortening processing process in the low bit rate scenario may affect performance (for example, in a shortening processing manner, a position of a high-reliability bit in a polar code may need to be located for a plurality of times, resulting in poor performance). Therefore, in the foregoing technical solution, rate matching is implemented by using the puncturing processing or repetition processing process.

Optionally, in the foregoing implementation, when a value of the target code length corresponding to the any code block in the C encoded code blocks is an even number, a quantity of bits corresponding to the any code block in the C encoded code blocks in the first cyclic buffer is the same as a quantity of bits corresponding to the any code block in the C code blocks in the second cyclic buffer; or when a value of the target code length corresponding to the any code block in the C encoded code blocks is an odd number, a quantity of bits corresponding to the any code block in the C encoded code blocks in the second cyclic buffer is one more than a quantity of bits corresponding to the any code block in the C encoded code blocks in the first cyclic buffer. Specifically, when the value of the target code length corresponding to the any code block in the C encoded code blocks is the even number, the quantity of bits corresponding to the any code block in the C encoded code blocks in the first cyclic buffer is the same as the quantity of bits corresponding to the any code block in the C code blocks in the second cyclic buffer, so that processing complexity can be reduced. Alternatively, when the value of the target code length corresponding to the any code block in the C encoded code blocks is the odd number, the quantity of bits corresponding to the any code block in the C encoded code blocks in the second cyclic buffer is one more than the quantity of bits corresponding to the any code block in the C encoded code blocks in the first cyclic buffer.

Optionally, when the value of the target code length corresponding to the any code block in the C encoded code blocks is the odd number, the quantity of bits corresponding to the any code block in the C encoded code blocks in the second cyclic buffer is one less than the quantity of bits corresponding to the any code block in the C encoded code blocks in the first cyclic buffer.

In a possible implementation, a quantity of bits corresponding to the first part is half of a quantity of bits corresponding to the encoded information of the any code block in the C code blocks; and/or a quantity of bits corresponding to the second part is half of a quantity of bits corresponding to the encoded information of the any code block in the C code blocks. Specifically, the quantity of bits corresponding to the first part (and/or the second part) is half of the quantity of bits corresponding to the encoded information of the any code block in the C code blocks. To be specific, the transmit end stores the information based on the first cyclic buffer and the second cyclic buffer, and separately reads, based on the target code length, the information stored in the first cyclic buffer and the information stored in the second cyclic buffer to obtain the target bit sequence, so as to reduce implementation complexity.

For example, in step S204, an example in which a code block length of the any code block in the C encoded code blocks is N is used. The first part of the any code block may be represented as $\{d_0, d_1, d_2 \ldots d_{N/2-1}\}$, and the second part of the any code block may be represented as $\{d_{N/2}, d_{N/2+1}, d_{N/2+2} \ldots d_{N-1}\}$. In step S204, the transmit end places the first part (that is, $\{d_0, d_1, d_2 \ldots d_{N/2-1}\}$) into the first cyclic buffer, places the second part (that is, $\{d_{N/2}, d_{N/2+1}, d_{N/2+2} \ldots d_{N-1}\}$) into the second cyclic buffer, and performs the following operations:

If the target code length ($E_i$) corresponding to the any code block meets $E_i \leq N$, the data $\{d_{N/2-E_i/2}, d_{N/2-E_i/2+1}, d_{N/2-E_i/2+2} \ldots d_{N/2-1}\}$ in the first cyclic buffer is first sent, and then the data $\{d_{N-E_i/2}, d_{N-E_i/2+1}, d_{N-E_i/2+2} \ldots d_{N-1}\}$ in the second buffer is sent.

If the target code length ($E_i$) corresponding to the any code block meets $E_i > N$, the data in the first cyclic buffer is sent from the beginning, and then $\{d_0, d_1, d_2 \ldots d_{E_i/2-N/2-1}\}$ continues to be sent; and then the data in the second cyclic buffer is sent from the beginning, and then $\{d_{N/2}, d_{N/2+1}, d_{N/2+2} \ldots d_{E_i/2-1}\}$ continues to be sent.

For example, the implementation process is shown in FIG. 6c.

An implementation example is the puncturing process in FIG. 6c. Ei indicates an actual sending length of each segment. When Ei<N, the puncturing mode is used. In this case, data of Ei/2 is placed in the first cyclic buffer (denoted as a first buffer in FIG. 6c) for sending, and data of Ei/2 is placed in the second cyclic buffer (denoted as a second buffer in FIG. 6c) for sending. A total size of the first buffer is N/2, and therefore data of N/2-Ei/2 is punctured. Data sending starts from N/2-Ei/2, that is, (N-Ei)/2, and ends at N/2-1. In the second buffer, data of first N/2-Ei/2 is also punctured. Therefore, data sending starts from N/2+N/2-Ei/2, that is, N/2+(N-Ei)/2.

Another implementation example is a repetition process in FIG. 6c. Data of Ei/2-N/2 in both the first cyclic buffer (denoted as the first buffer in FIG. 6c) and the second cyclic buffer (denoted as the second buffer in FIG. 6c) is repeated. Therefore, in the first buffer, data sending starts from 0 to N/2-1, then is back to the position 0, and then ends at a position (Ei-N)/2 (optionally, data at the position (Ei-N)/2 is not available). Similarly, for the second buffer, data sending starts from N/2 to N-1, then is back to the position N/2, and then is repeatedly performed to end at the position N/2+(Ei-N)/2 (optionally, data at the position N/2+(Ei-N)/2 is not available).

Optionally, if the target code length ($E_i$) corresponding to the any code block cannot be exactly divided by 2, a quantity of to-be-sent data in a next cyclic buffer is increased by 1.

S205: The receive end determines that a quantity of code blocks corresponding to the first information is C.

In this embodiment, after the receive end receives the first information in step S204, the receive end determines, in step S205, that the quantity of code blocks corresponding to the first information is C.

In a possible implementation, in step S205, that the receive end determines that a quantity of code blocks corresponding to the first information is C includes: The receive end determines, based on k and a target bit rate, that the quantity of code blocks is C. Specifically, in the process of determining the quantity of code blocks, the receive end may determine, based on k and the target bit rate, that the quantity of code blocks is C. In other words, the receive end determines, based on the quantity k of bits of the to-be-encoded information and the target bit rate of polar encoding, that the quantity of polar-encoded code blocks is C. Compared with an implementation process in which the quantity of code blocks is determined based on k, encoding performance may jitter. In the foregoing technical solution, the target bit rate is added as one of bases for determining the quantity of code blocks, so that the encoding performance jitter can be avoided, and encoding performance of polar encoding can be improved.

It should be understood that the quantity k of bits of the to-be-encoded information and the target bit rate meet k/E=R, where E is a target code length, and R is the target bit rate. In other words, any two of three parameters: the quantity of bits of the to-be-encoded information, the target bit rate, and the target code length may be used to determine a value of the other. Therefore, in this implementation, that the quantity of code blocks is determined as C based on k and the target bit rate may also be represented as that the quantity of code blocks is determined as C based on any two of k, the target bit rate, and the target code length.

Optionally, the receive end determines the target bit rate in a preconfigured manner.

Optionally, the receive end determines the target bit rate based on an indication (or a configuration) of another device (for example, a transmit end).

It should be noted that, for a process in which the receive end determines C based on the target bit rate (and the target code length or k), refer to the foregoing process in which the transmit end determines C based on the target bit rate (and the target code length or k) in step S202, and implement corresponding technical effect. Details are not described herein again.

S206: The receive end determines, based on C, the C encoded code blocks corresponding to the first information.

In this embodiment, after the receive end determines, in step S205, that the quantity of code blocks is C, the receive end determines, in step S206 based on the quantity C of code blocks, the C encoded code blocks corresponding to the first information.

In a possible implementation, that the receive end determines, based on C, C encoded code blocks corresponding to the first information includes: The receive end determines a target bit sequence corresponding to the first information; the receive end determines, based on a target code length corresponding to any code block in the C encoded code blocks, bit information of the target bit sequence in a first cyclic buffer and bit information of the target bit sequence in a second cyclic buffer; the receive end determines a first part of encoded information of the any code block in the C encoded code blocks based on the bit information of the target bit sequence in the first cyclic buffer, and determines a second part of the encoded information of the any code block in the C encoded code blocks based on the bit information of the target bit sequence in the second cyclic buffer; and the receive end determines the any code block in the C encoded code blocks based on the first part and the second part. Specifically, in a process in which the receive end determines, based on C, the C encoded code blocks corresponding to the first information, the receive end determines information that is separately stored in at least two cyclic buffers (including the first cyclic buffer and the second cyclic buffer) and that is of the target bit sequence corresponding to the first information, and the receive end performs restoration based on the target code length and the information stored in the at least two cyclic buffers to obtain the any code block in the C encoded code blocks, to simplify a rate matching process, thereby reducing performance loss while reducing complexity.

In a possible implementation, when the target code length corresponding to the any code block in the C encoded code blocks is less than or equal to a bit length corresponding to the any code block, the target bit sequence includes a first sequence and a second sequence, where the first sequence includes data obtained after puncturing processing is performed on data in the first cyclic buffer, and a sequence length of the first sequence is less than or equal to a sequence length of the first part; and the second sequence includes data obtained after puncturing processing is performed on data in the second cyclic buffer, and a sequence length of the second sequence is less than or equal to a sequence length of the second part; or when the target code length corresponding to the any code block in the C encoded code blocks is greater than a bit length corresponding to the any code block, the target bit sequence includes one sequence, where the one sequence includes data obtained after puncturing processing is performed on data in the first cyclic buffer and data obtained after puncturing processing is performed on data in the second cyclic buffer, and a sequence length of the sequence is greater than the bit length corresponding to the any code block. Specifically, the receive end performs puncturing processing or repetition processing based on the target code length corresponding to the any code block in the C encoded code blocks and the bit length corresponding to the any code block, to restore the C encoded code blocks corresponding to the target bit information.

In a possible implementation, when a value of the target code length corresponding to the any code block in the C encoded code blocks is an even number, a quantity of bits corresponding to the any code block in the C encoded code blocks in the first cyclic buffer is the same as a quantity of bits corresponding to the any code block in the C code blocks in the second cyclic buffer; or when a value of the target code length corresponding to the any code block in the C encoded code blocks is an odd number, a quantity of bits corresponding to the any code block in the C encoded code blocks in the second cyclic buffer is one more than a quantity of bits corresponding to the any code block in the C encoded code blocks in the first cyclic buffer. Specifically, when the value of the target code length corresponding to the any code block in the C encoded code blocks is the even number, the quantity of bits corresponding to the any code block in the C encoded code blocks in the first cyclic buffer is the same as the quantity of bits corresponding to the any code block in the C code blocks in the second cyclic buffer, so that processing complexity can be reduced. Alternatively, when the value of the target code length corresponding to the any code block in the C encoded code blocks is the odd number, the quantity of bits corresponding to the any code block in the C encoded code blocks in the second cyclic buffer is one more than the quantity of bits corresponding to the any code block in the C encoded code blocks in the first cyclic buffer.

Optionally, when the value of the target code length corresponding to the any code block in the C encoded code blocks is the odd number, the quantity of bits corresponding to the any code block in the C encoded code blocks in the second cyclic buffer is one less than the quantity of bits corresponding to the any code block in the C encoded code blocks in the first cyclic buffer.

In a possible implementation, a quantity of bits corresponding to the first part is half of a quantity of bits corresponding to the encoded information of the any code block in the C code blocks; and/or a quantity of bits corresponding to the second part is half of a quantity of bits corresponding to the encoded information of the any code block in the C code blocks. Specifically, the quantity of bits corresponding to the first part (and/or the second part) is half of the quantity of bits corresponding to the encoded information of the any code block in the C code blocks. To be specific, the transmit end stores the information based on the first cyclic buffer and the second cyclic buffer, and separately reads, based on the target code length, the information stored in the first cyclic buffer and the information stored in the second cyclic buffer to obtain the target bit sequence, so as to reduce implementation complexity.

It should be noted that a process in which the receive end determines, based on C, the target bit sequence corresponding to the first information in step S206, and determines the C encoded code blocks is an inverse process in which the transmit end sends, in step S204, the target bit sequence corresponding to the C encoded code blocks. For an implementation process and corresponding beneficial effect, refer to the foregoing descriptions. Details are not described herein again.

S207: The receive end determines k pieces of bit information based on the C encoded code blocks.

In this embodiment, after the receive end obtains the C encoded code blocks in step S206, the receive end determines the k pieces of bit information based on the C encoded code blocks in step S207.

In a possible implementation, that the receive end determines the k pieces of bit information based on the C encoded code blocks includes: The receive end determines C initial code blocks based on the C encoded code blocks, where an $i^{th}$ initial code block in the C initial code blocks is determined based on an $i^{th}$ encoded code block in the C encoded code blocks, and i is traversed from 1 to C; and the receive end performs decoding based on the C initial code blocks to obtain the k pieces of bit information. Specifically, in a process of determining the k pieces of bit information based on the C encoded code blocks, the receive end determines the C initial code blocks based on the C encoded code blocks. The $i^{th}$ initial code block in the C initial code blocks is determined based on the $i^{th}$ encoded code block in the C encoded code blocks, so that the C encoded code blocks actually received by the receive end correspond to the C initial code blocks corresponding to the k pieces of bit information, to reduce processing complexity.

In a possible implementation, that an $i^{th}$ initial code block in the C initial code blocks is determined based on an $i^{th}$ encoded code block in the C encoded code blocks includes: in at least one initial code block in the C initial code blocks, an $i^{th}$ initial code block is the $i^{th}$ encoded code block in the C encoded code blocks; and in initial code blocks other than the at least one initial code block in the C initial code blocks, a coupling result of x bits in the $i^{th}$ initial code block and x bits in a $j^{th}$ initial code block is x bits in the $i^{th}$ encoded code block in the C encoded code blocks, and remaining N-x bits in the $i^{th}$ initial code block are remaining N-x bits in the $i^{th}$ encoded code block in the C encoded code blocks. A quantity of the encoded code blocks is a positive integer, x is less than or equal to N, i is not equal to j, both i and j are less than or equal to C, and both i and j are positive integers. Specifically, in the C initial code blocks, the $i^{th}$ initial code block in the at least one initial code block is the same as the $i^{th}$ encoded code block in the C encoded code blocks. In addition, in the initial code blocks other than the at least one initial code block, the coupling result of the $i^{th}$ initial code block and the $j^{th}$ initial code block is the x bits in the $i^{th}$ encoded code block, so that when the x bits in the $i^{th}$ encoded code block are used to transmit information about the x bits in the $i^{th}$ initial code block, the x bits in the $i^{th}$ encoded code block, used as the coupling result, may be further configured to check the $i^{th}$ initial code block and the $j^{th}$ initial code block, to improve information transmission security.

In addition, because the x bits in the $i^{th}$ encoded code block, used as the coupling result, may be further used to check the $i^{th}$ initial code block and the $j^{th}$ initial code block, so that the transmit end does not need to add a cyclic redundancy code (cyclic redundancy code, CRC) check code of a code block (code block, CB) to each encoded code block in the C encoded code blocks, so that check on the code block can be implemented while overheads are reduced, to improve performance.

Optionally, that an $i^{th}$ initial code block in the C initial code blocks is determined based on an $i^{th}$ encoded code block in the C encoded code blocks includes: in the C initial code blocks, a coupling result of x bits in the $i^{th}$ initial code block and x bits in a $j^{th}$ initial code block is x bits in the $i^{th}$ encoded code block in the C encoded code blocks, and remaining N-x bits in the $i^{th}$ initial code block are remaining N-x bits in the $i^{th}$ encoded code block in the C encoded code blocks. A quantity of code blocks of the remaining encoded code blocks is a positive integer, x is less than or equal to N, i is not equal to j, both i and j are less than or equal to C, and both i and j are positive integers. In other words, any code block in the C encoded code blocks is a coupling result of at least two code blocks in the C code blocks.

In a possible implementation, x is equal to N/2.

Based on the foregoing technical solution, quantities of bits corresponding to any code block in the C initial code blocks and the any code block in the C encoded code blocks are N, and the x bits of the $i^{th}$ encoded code block in some or all of the C encoded code blocks are a coupling result. Therefore, in this implementation, when x is equal to N/2, both the x bits in the $i^{th}$ initial code block and the x bits in the $j^{th}$ initial code block that participate in coupling are half of the quantity of bits corresponding to the any code block, that is, information in a buffer can be used through semi-coupling in a ping-pong manner (for example, the x bits in the $j^{th}$ initial code block in the C initial code blocks may be used as the x bits in the $j^{th}$ initial code block in the C encoded code blocks, and the x bits in the $j^{th}$ initial code block in the C initial code blocks may also be used to determine the x bits in the $i^{th}$ initial code block in the C encoded code blocks), so that processing complexity is reduced, and system performance is improved.

Optionally, x may be another value, for example, N/3, N/4, or N/8.

Optionally, in the foregoing implementation, the coupling result is an exclusive OR result.

Optionally, the coupling result is an XNOR result, or is another implementation.

Optionally, in the foregoing implementation, i=j-1, or i=j+1. Specifically, i=j-1, or i=j+1, that is, the ith initial code block and the jth initial code block that participate in coupling are adjacent code blocks in the C initial code blocks, to reduce processing complexity and improve system performance.

It should be noted that a process in which the receive end determines the k pieces of bit information based on the C encoded code blocks in step S207 is an inverse process in which the transmit end performs polar encoding on the to-be-encoded information based on C to obtain the C encoded code blocks in step S203. For an implementation process and corresponding beneficial effect, refer to the foregoing descriptions. Details are not described herein again.

In conclusion, embodiments of this application have the following advantages:

In some embodiments, in the implementation in which the transmit end performs polar code encoding based on the quantity C of code blocks, implementation complexity of the polar code can be reduced, to improve communication efficiency.

In some embodiments, in the process of determining the quantity of code blocks, the transmit end may determine, based on k and the target bit rate, that the quantity of code blocks is C. In other words, the transmit end determines, based on the quantity k of bits of the to-be-encoded information and the target bit rate of polar encoding, that the quantity of polar-encoded code blocks is C. Compared with an implementation process in which the quantity of code blocks is determined based on k, encoding performance may jitter. In the foregoing technical solution, the target bit rate is added as one of bases for determining the quantity of code blocks, so that the encoding performance jitter can be avoided, and encoding performance of polar encoding can be improved.

In some embodiments, in the process of obtaining the C encoded code blocks, after the transmit end performs polar encoding on the to-be-encoded information based on the quantity C of code blocks to obtain the C initial code blocks, the transmit end determines the C encoded code blocks based on the C initial code blocks. The $i^{th}$ encoded code block in the C encoded code blocks is determined based on the $i^{th}$ initial code block in the C initial code blocks, so that the C encoded code blocks actually sent by the transmit end correspond to the C initial code blocks corresponding to the to-be-encoded information, to reduce processing complexity.

In some embodiments, the transmit end needs to perform rate matching in the process of sending the C encoded code blocks. To be specific, the transmit end stores the information based on the at least two cyclic buffers (including the first cyclic buffer and the second cyclic buffer), reads, based on the target code length, the information stored in the at least two cyclic buffers to obtain and send the target bit sequence, to simplify the rate matching process, reduce complexity, and reduce performance loss.

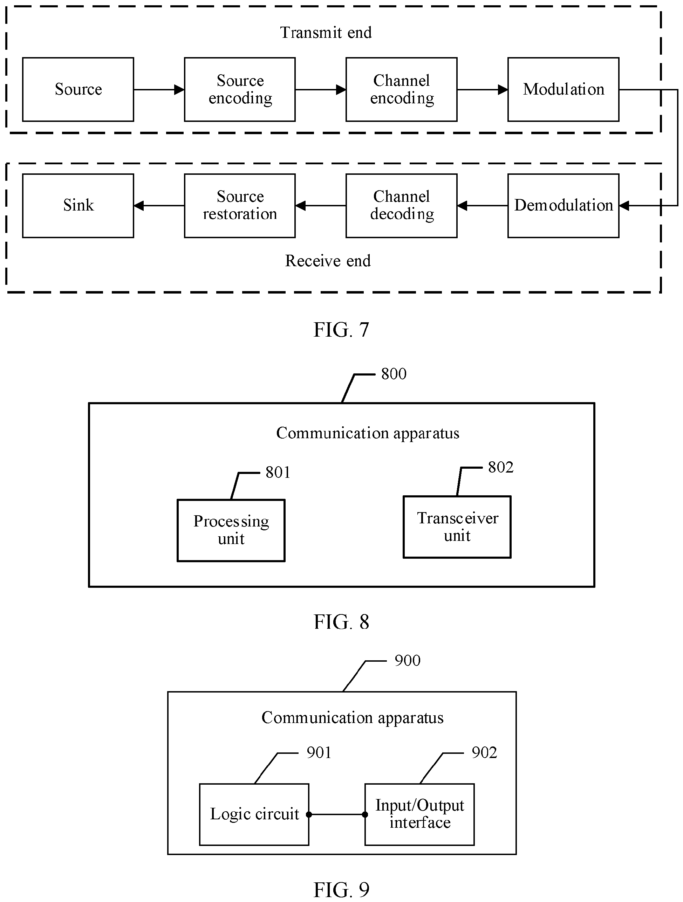

For example, the foregoing embodiment may be applied to a scenario shown in FIG. 7. For example, in an encoding process related to the transmit end in this application, a "source" module, a "source encoding" module, a "channel encoding" module, and a "modulation" module shown in FIG. 7 may be executed, to send the C encoded code blocks. In a decoding process related to the receive end in this application, a "demodulation" module, a "channel decoding" module, a "source decoding" module, and a "sink" module shown in FIG. 7 may be executed, to determine the k pieces of bit information. This application mainly relates to source encoding, channel encoding, channel decoding, and source restoration.

Optionally, an input of the "source encoding" module is source data, and an output is data after source encoding. Source encoding is to compress sparse source data, to improve communication efficiency. An input of the "channel encoding" module is compressed data after source encoding, and an output is a result of channel encoding. A purpose is to improve correctness of channel transmission.

Optionally, an input of the "channel decoding" module is an LLR generated by the demodulation module, and a decoding result is a result of source encoding. If the result of source encoding cannot be restored, decoding fails. A result of the "source decoding" module is source data, which can be restored in lossy or lossless mode.

Refer to FIG. 8. An embodiment of this application provides a diagram of a communication apparatus 800. The communication apparatus 800 can implement functions of a transmit end (or a receive end) in the foregoing method embodiments, and therefore can also implement beneficial effect of the foregoing method embodiments. In this embodiment of this application, the communication apparatus 800 may be the transmit end (or the receive end), or may be an integrated circuit, an element, or the like in the transmit end (or the receive end), for example, a chip.

When the communication apparatus 800 is the transmit end, the apparatus includes a transceiver unit 802 and a processing unit 801. The processing unit 801 is configured to obtain to-be-encoded information, where the to-be-encoded information includes k bits, and k is a positive integer. The processing unit 801 is further configured to determine that a quantity of code blocks is C, where C is a positive integer. The processing unit 801 is further configured to perform polar encoding on the to-be-encoded information based on C, to obtain C encoded code blocks. The transceiver unit 802 is configured to send the C encoded code blocks.

In a possible implementation, the processing unit 801 is specifically configured to determine, based on k and a target bit rate, that the quantity of code blocks is C.

In a possible implementation, the target bit rate is one of at least two bit rates.

In a possible implementation, the target bit rate is 1/8, 1/4, or 1/2.

In a possible implementation, the processing unit 801 is specifically configured to:

when the target bit rate is 1/8 and k is less than a first threshold, determine that C is 1, or
when the target bit rate is 1/8, k is greater than or equal to the first threshold, and k is less than a second threshold, determine that C is 2, or
when the target bit rate is 1/8 and k is greater than or equal to the second threshold, determine that C is 3; or
when the target bit rate is 1/4 and k is less than a third threshold, determine that C is 1, or
when the target bit rate is 1/4, k is greater than or equal to the third threshold, and k is less than a fourth threshold, determine that C is 2, or
when the target bit rate is 1/4 and k is greater than or equal to the fourth threshold, determine that C is 3; or
when the target bit rate is 1/2 and k is less than a fifth threshold, determine that C is 1, or
when the target bit rate is 1/2 and k is greater than or equal to the fifth threshold, determine that C is 2.

In a possible implementation,

the first threshold is greater than or equal to 180 and the first threshold is less than or equal to 205; or
the second threshold is greater than or equal to 310 and the second threshold is less than or equal to 355; or
the third threshold is greater than or equal to 175, and the third threshold is less than or equal to 205; or
the fourth threshold is greater than or equal to 310, and the fourth threshold is less than or equal to 335; or
the fifth threshold is greater than or equal to 290, and the fifth threshold is less than or equal to 310.

In a possible implementation, the processing unit 801 is specifically configured to: perform polar encoding on the to-be-encoded information based on C, to obtain C initial code blocks; and determine the C encoded code blocks based on the C initial code blocks, where an $i^{th}$ encoded code block in the C encoded code blocks is determined based on an $i^{th}$ initial code block in the C initial code blocks, and i is traversed from 1 to C.

In a possible implementation, that an $i^{th}$ encoded code block in the C encoded code blocks is determined based on an $i^{th}$ initial code block in the C initial code blocks includes: in at least one encoded code block in the C encoded code blocks, the $i^{th}$ encoded code block is the $i^{th}$ initial code block in the C initial code blocks; and in encoded code blocks other than the at least one encoded code block in the C encoded code blocks, x bits in the $i^{th}$ encoded code block are a coupling result of x bits in the $i^{th}$ initial code block in the C initial code blocks and x bits in a $j^{th}$ initial code block, and remaining N-x bits in the $i^{th}$ encoded code block are remaining N-x bits in the $i^{th}$ initial code block in the C initial code blocks. A quantity of the encoded code blocks is a positive integer, x is less than or equal to N, i is not equal to j, both i and j are less than or equal to C, and both i and j are positive integers.

In a possible implementation, x is equal to N/2.

In a possible implementation, the coupling result is an exclusive OR result.

In a possible implementation, i=j-1, or i=j+1.

In a possible implementation, the transceiver unit 802 is specifically configured to: store a first part of encoded information of any code block in the C encoded code blocks into a first cyclic buffer, and store a second part of the encoded information of the any code block in the C encoded code blocks into a second cyclic buffer; read bit information in the first cyclic buffer and bit information in the second cyclic buffer based on a target code length corresponding to the any code block in the C encoded code blocks, and use the bit information in the first cyclic buffer and the bit information in the second cyclic buffer as a target bit sequence; and send the target bit sequence.

In a possible implementation, when the target code length corresponding to the any code block in the C encoded code blocks is less than or equal to a bit length corresponding to the any code block, the target bit sequence includes a first sequence and a second sequence, where the first sequence includes data obtained after puncturing processing is performed on data in the first cyclic buffer, and a sequence length of the first sequence is less than or equal to a sequence length of the first part; and the second sequence includes data obtained after puncturing processing is performed on data in the second cyclic buffer, and a sequence length of the second sequence is less than or equal to a sequence length of the second part; or when the target code length corresponding to the any code block in the C encoded code blocks is greater than a bit length corresponding to the any code block, the target bit sequence includes one sequence, where the one sequence includes data obtained after puncturing processing is performed on data in the first cyclic buffer and data obtained after puncturing processing is performed on data in the second cyclic buffer, and a sequence length of the sequence is greater than the bit length corresponding to the any code block.

In a possible implementation, when a value of the target code length corresponding to the any code block in the C encoded code blocks is an even number, a quantity of bits corresponding to the any code block in the C encoded code blocks in the first cyclic buffer is the same as a quantity of bits corresponding to the any code block in the C code blocks in the second cyclic buffer; or when a value of the target code length corresponding to the any code block in the C encoded code blocks is an odd number, a quantity of bits corresponding to the any code block in the C encoded code blocks in the second cyclic buffer is one more than a quantity of bits corresponding to the any code block in the C encoded code blocks in the first cyclic buffer.

Optionally, when the value of the target code length corresponding to the any code block in the C encoded code blocks is the odd number, the quantity of bits corresponding to the any code block in the C encoded code blocks in the second cyclic buffer is one less than the quantity of bits corresponding to the any code block in the C encoded code blocks in the first cyclic buffer.

In a possible implementation, a quantity of bits corresponding to the first part is half of a quantity of bits corresponding to the encoded information of the any code block in the C code blocks; and/or a quantity of bits corresponding to the second part is half of a quantity of bits corresponding to the encoded information of the any code block in the C code blocks.

When the communication apparatus 800 is the receive end, the apparatus includes a transceiver unit 802 and a processing unit 801. The transceiver unit 802 is configured to receive first information, where the first information is obtained based on k pieces of bit information, and k is a positive integer. The processing unit 801 is configured to determine that a quantity of code blocks corresponding to the first information is C, where C is a positive integer. The processing unit 801 is further configured to determine, based on C, C encoded code blocks corresponding to the first information. The processing unit 801 is further configured to determine the k pieces of bit information based on the C encoded code blocks.

In a possible implementation, the processing unit 801 is specifically configured to determine, based on k and a target bit rate, that the quantity of code blocks is C.

In a possible implementation, the target bit rate is one of at least two bit rates.

In a possible implementation, the target bit rate is 1/8, 1/4, or 1/2.

In a possible implementation, the determining, based on k and a target bit rate, that the quantity of code blocks is C includes:

when the target bit rate is 1/8 and k is less than a first threshold, determining that C is 1, or
when the target bit rate is 1/8, k is greater than or equal to the first threshold, and k is less than a second threshold, determining that C is 2, or
when the target bit rate is 1/8 and k is greater than or equal to the second threshold, determining that C is 3; or
when the target bit rate is 1/4 and k is less than a third threshold, determining that C is 1, or
when the target bit rate is 1/4, k is greater than or equal to the third threshold, and k is less than a fourth threshold, determining that C is 2, or
when the target bit rate is 1/4 and k is greater than or equal to the fourth threshold, determining that C is 3; or
when the target bit rate is 1/2 and k is less than a fifth threshold, determining that C is 1, or
when the target bit rate is 1/2 and k is greater than or equal to the fifth threshold, determining that C is 2.

In a possible implementation,

the first threshold is greater than or equal to 180 and the first threshold is less than or equal to 205; or
the second threshold is greater than or equal to 310 and the second threshold is less than or equal to 355; or
the third threshold is greater than or equal to 175, and the third threshold is less than or equal to 205; or
the fourth threshold is greater than or equal to 310, and the fourth threshold is less than or equal to 335; or

the fifth threshold is greater than or equal to 290, and the fifth threshold is less than or equal to 310.

In a possible implementation, the processing unit 801 is specifically configured to: determine C initial code blocks based on the C encoded code blocks, where an $i^{th}$ initial code block in the C initial code blocks is determined based on an $i^{th}$ encoded code block in the C encoded code blocks, and i is traversed from 1 to C; and perform decoding based on the C initial code blocks to obtain the k pieces of bit information.

In a possible implementation, that an $i^{th}$ initial code block in the C initial code blocks is determined based on an $i^{th}$ encoded code block in the C encoded code blocks includes: in at least one initial code block in the C initial code blocks, an $i^{th}$ initial code block is the $i^{th}$ encoded code block in the C encoded code blocks; and in initial code blocks other than the at least one initial code block in the C initial code blocks, a coupling result of x bits in the $i^{th}$ initial code block and x bits in a $j^{th}$ initial code block is x bits in the $i^{th}$ encoded code block in the C encoded code blocks, and remaining N-x bits in the $i^{th}$ initial code block are remaining N-x bits in the $i^{th}$ encoded code block in the C encoded code blocks. A quantity of the encoded code blocks is a positive integer, x is less than or equal to N, i is not equal to j, both i and j are less than or equal to C, and both i and j are positive integers.

In a possible implementation, x is equal to N/2.

In a possible implementation, the coupling result is an exclusive OR result.

In a possible implementation, i=j-1, or i=j+1.

In a possible implementation, the processing unit 801 is specifically configured to: determine a target bit sequence corresponding to the first information; determine, based on a target code length corresponding to any code block in the C encoded code blocks, bit information of the target bit sequence in a first cyclic buffer and bit information of the target bit sequence in a second cyclic buffer; determine a first part of encoded information of the any code block in the C encoded code blocks based on the bit information of the target bit sequence in the first cyclic buffer, and determine a second part of the encoded information of the any code block in the C encoded code blocks based on the bit information of the target bit sequence in the second cyclic buffer; and determine the any code block in the C encoded code blocks based on the first part and the second part.

In a possible implementation, when the target code length corresponding to the any code block in the C encoded code blocks is less than or equal to a bit length corresponding to the any code block, the target bit sequence includes a first sequence and a second sequence, where the first sequence includes data obtained after puncturing processing is performed on data in the first cyclic buffer, and a sequence length of the first sequence is less than or equal to a sequence length of the first part; and the second sequence includes data obtained after puncturing processing is performed on data in the second cyclic buffer, and a sequence length of the second sequence is less than or equal to a sequence length of the second part; or when the target code length corresponding to the any code block in the C encoded code blocks is greater than a bit length corresponding to the any code block, the target bit sequence includes one sequence, where the one sequence includes data obtained after puncturing processing is performed on data in the first cyclic buffer and data obtained after puncturing processing is performed on data in the second cyclic buffer, and a sequence length of the sequence is greater than the bit length corresponding to the any code block.

In a possible implementation, when a value of the target code length corresponding to the any code block in the C encoded code blocks is an even number, a quantity of bits corresponding to the any code block in the C encoded code blocks in the first cyclic buffer is the same as a quantity of bits corresponding to the any code block in the C code blocks in the second cyclic buffer; or when a value of the target code length corresponding to the any code block in the C encoded code blocks is an odd number, a quantity of bits corresponding to the any code block in the C encoded code blocks in the second cyclic buffer is one more than a quantity of bits corresponding to the any code block in the C encoded code blocks in the first cyclic buffer.

In a possible implementation, a quantity of bits corresponding to the first part is half of a quantity of bits corresponding to the encoded information of the any code block in the C code blocks; and/or a quantity of bits corresponding to the second part is half of a quantity of bits corresponding to the encoded information of the any code block in the C code blocks.

It should be noted that for specific content such as an information execution process of the units of the communication apparatus 800, refer to descriptions in the foregoing method embodiments of this application. Details are not described herein again.

FIG. 9 is a diagram of another structure of a communication apparatus 900 according to this application. The communication apparatus 900 includes a logic circuit 901 and an input/output interface 902. The communication apparatus 900 may be a chip or an integrated circuit.

The transceiver unit 802 shown in FIG. 8 may be a communication interface. The communication interface may be the input/output interface 902 in FIG. 9. The input/output interface 902 may include an input interface and an output interface. Alternatively, the communication interface may be a transceiver circuit, and the transceiver circuit may include an input interface circuit and an output interface circuit. In addition, the processing unit 801 shown in FIG. 8 may be the logic circuit 901 in FIG. 9.

For example, when the communication apparatus 900 is the chip or the integrated circuit of the foregoing transmit end, the logic circuit 901 is configured to obtain to-be-encoded information, where the to-be-encoded information includes k bits, and k is a positive integer. The logic circuit 901 is further configured to determine that a quantity of code blocks is C, where C is a positive integer. The logic circuit 901 is further configured to perform polar encoding on the to-be-encoded information based on C, to obtain C encoded code blocks. The input/output interface 902 is configured to send the C encoded code blocks.

For example, when the communication apparatus 900 is the chip or the integrated circuit of the foregoing receive end, the input/output interface 902 is configured to receive first information, where the first information is obtained based on k pieces of bit information, and k is a positive integer. The logic circuit 901 is configured to determine that a quantity of code blocks corresponding to the first information is C, where C is a positive integer. The logic circuit 901 is further configured to determine, based on C, C encoded code blocks corresponding to the first information. The logic circuit 901 is further configured to determine the k pieces of bit information based on the C encoded code blocks.

In a possible implementation, the logic circuit 901 may further perform other steps performed by the processing unit 801 and implement corresponding beneficial effect, and the input/output interface 902 may further perform other steps performed by the transceiver unit 802 and implement corresponding beneficial effect. Details are not described herein again.

In a possible implementation, the logic circuit 901 may be a processing apparatus, and some or all functions of the processing apparatus may be implemented through software. Some or all functions of the processing apparatus may be implemented through software.

Optionally, the processing apparatus may include a memory and a processor. The memory is configured to store a computer program, and the processor reads and executes the computer program stored in the memory, to perform corresponding processing and/or steps in any method embodiment.

Optionally, the processing apparatus may include only a processor. A memory configured to store a computer program is located outside the processing apparatus, and the processor is connected to the memory through a circuit/wire, to read and execute the computer program stored in the memory. The memory and the processor may be integrated together, or may be physically independent of each other.

Optionally, the processing apparatus may be one or more chips, or one or more integrated circuits. For example, the processing apparatus may be one or more field-programmable gate arrays (field-programmable gate array, FPGA), application-specific integrated circuits (application-specific integrated circuit, ASIC), system on chips (system on chip, SoC), central processor units (central processor unit, CPU), network processors (network processor, NP), digital signal processors (digital signal processor, DSP), micro controller units (micro controller unit, MCU), programmable logic devices (programmable logic device, PLD), or another integrated chip, or any combination of the foregoing chips or processors.

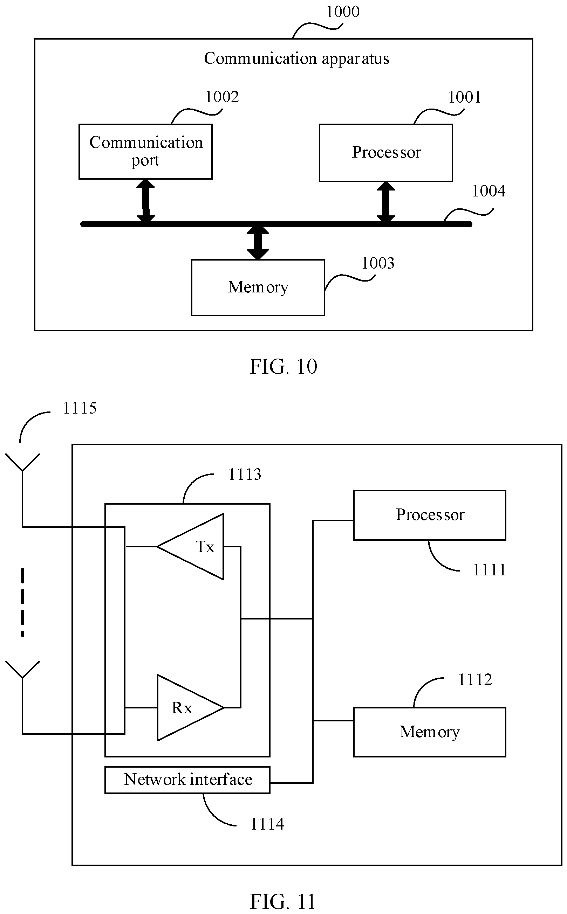

FIG. 10 shows a communication apparatus 1000 involved in the foregoing embodiment according to an embodiment of this application. The communication apparatus 1000 may be specifically a first communication apparatus used as a transmit end or a second communication apparatus used as a receive end in the foregoing embodiment. In an example shown in FIG. 10, the transmit end or the receive end is implemented through a terminal device (or a component in the terminal device). In a possible diagram of a logical structure of the communication apparatus 1000, the communication apparatus 1000 may include but is not limited to at least one processor 1001 and a communication port 1002. Further, optionally, the apparatus may include at least one of a memory 1003 and a bus 1004. In this embodiment of this application, the at least one processor 1001 is configured to perform control processing on an action of the communication apparatus 1000.

In addition, the processor 1001 may be a central processing unit, a general-purpose processor, a digital signal processor, an application-specific integrated circuit, a field programmable gate array or another programmable logic device, a transistor logic device, a hardware component, or any combination thereof. The processor may implement or execute various example logical blocks, modules, and circuits described with reference to content disclosed in this application. Alternatively, the processor may be a combination of processors implementing a computing function, for example, a combination of one or more microprocessors, or a combination of a digital signal processor and a microprocessor. It may be clearly understood by a person skilled in the art that, for the purpose of convenient and brief description, for a detailed working process of the foregoing system, apparatus, and unit, refer to a corresponding process in the foregoing method embodiments, and details are not described herein again.

It should be noted that the communication apparatus 1000 shown in FIG. 10 may be specifically configured to implement steps implemented by the transmit end or the receive end in the foregoing method embodiments, and implement technical effect corresponding to the transmit end or the receive end. For a specific implementation of the communication apparatus shown in FIG. 10, refer to descriptions in the foregoing method embodiments. Details are not described herein again.

FIG. 11 is a diagram of a structure of a communication apparatus 1100 in the foregoing embodiment according to an embodiment of this application. The communication apparatus 1100 may be specifically a first communication apparatus used as a transmit end or a second communication apparatus used as a receive end in the foregoing embodiment. In an example shown in FIG. 11, the transmit end or the receive end is implemented through a network device (or a component in the network device). For a structure of the communication apparatus, refer to the structure shown in FIG. 11.

The communication apparatus 1100 includes at least one processor 1111 and at least one network interface 1114. Further, optionally, the communication apparatus further includes at least one memory 1112, at least one transceiver 1113, and one or more antennas 1115. The processor 1111, the memory 1112, the transceiver 1113, and the network interface 1114 are connected, for example, connected through a bus. In this embodiment of this application, connections may include various interfaces, transmission lines, buses, or the like. This is not limited in embodiments. The antennas 1115 are connected to the transceiver 1113. The network interface 1114 is configured to enable the communication apparatus to communicate with another communication device through a communication link. For example, the network interface 1114 may include a network interface between the communication apparatus and a core network device, for example, an S1 interface. The network interface may include a network interface between the communication apparatus and another communication apparatus (for example, another network device or core network device), for example, an X2 or Xn interface.

The processor 1111 is mainly configured to process a communication protocol and communication data, control the entire communication apparatus, execute a software program, and process data of the software program, for example, is configured to support the communication apparatus in performing actions described in the embodiments. The communication apparatus may include a baseband processor and a central processing unit. The baseband processor is mainly configured to process the communication protocol and the communication data. The central processing unit is mainly configured to control the entire terminal device, execute the software program, and process the data of the software program. Functions of the baseband processor and the central processing unit may be integrated into the processor 1111 in FIG. 11. A person skilled in the art may understand that the baseband processor and the central processing unit each may be an independent processor, and are interconnected by using a technology such as a bus. A person skilled in the art may understand that the terminal device may include a plurality of baseband processors to adapt to different network standards, and the terminal device may include a plurality of central processing units to enhance processing capabilities of the terminal device, and components of the terminal device may be connected by using various buses. The baseband processor may also be expressed as a baseband processing circuit or a baseband processing chip. The central processing unit may also be expressed as a central processing circuit or a central processing chip. A function of processing the communication protocol and the communication data may be built in the processor, or may be stored in the memory in a form of a software program, and the processor executes the software program to implement a baseband processing function.

The memory is mainly configured to store the software program and data. The memory 1112 may exist independently, and is connected to the processor 1111. Optionally, the memory 1112 may be integrated with the processor 1111, for example, integrated into a chip. The memory 1112 can store program code for executing the technical solutions in embodiments of this application, and the processor 1111 controls the execution. Various types of executed computer program code may also be considered as a driver of the processor 1111.

FIG. 11 merely shows one memory and one processor. In an actual terminal device, there may be a plurality of processors and a plurality of memories. The memory may also be referred to as a storage medium, a storage device, or the like. The memory may be a storage element on a same chip as the processor, that is, an on-chip storage element, or may be an independent storage element. This is not limited in this embodiment of this application.

The transceiver 1113 may be configured to support receiving or sending of a radio frequency signal between the communication apparatus and the terminal. The transceiver 1113 may be connected to the antenna 1115. The transceiver 1113 includes a transmitter Tx and a receiver Rx. Specifically, the one or more antennas 1115 may receive a radio frequency signal. The receiver RX of the transceiver 1113 is configured to: receive the radio frequency signal from the antenna, convert the radio frequency signal into a digital baseband signal or a digital intermediate frequency signal, and provide the digital baseband signal or the digital intermediate frequency signal for the processor 1111, so that the processor 1111 further processes (for example, demodulates or decodes) the digital baseband signal or the digital intermediate frequency signal. In addition, the transmitter Tx of the transceiver 1113 is further configured to: receive a modulated digital baseband signal or digital intermediate frequency signal from the processor 1111, convert the modulated digital baseband signal or digital intermediate frequency signal into a radio frequency signal, and send the radio frequency signal via the one or more antennas 1115. Specifically, the receiver Rx may selectively perform one or more levels of down-mixing processing and analog-to-digital conversion processing on the radio frequency signal to obtain the digital baseband signal or the digital medium-frequency signal. A sequence of the down-mixing processing and the analog-to-digital conversion processing is adjustable. The transmitter Tx may selectively perform one or more levels of up-mixing processing and digital-to-analog conversion processing on the modulated digital baseband signal or digital medium-frequency signal to obtain the radio frequency signal. A sequence of the up-mixing processing and the digital-to-analog conversion processing is adjustable. The digital baseband signal and the digital medium-frequency signal may be collectively referred to as a digital signal.

The transceiver 1113 may also be referred to as a transceiver unit, a transceiver machine, a transceiver apparatus, or the like. Optionally, a device configured to implement a receiving function in the transceiver unit may be considered as a receiving unit, and a device configured to implement a sending function in the transceiver unit may be considered as a sending unit. In other words, the transceiver unit includes a receiving unit and a sending unit. The receiving unit may also be referred to as a receiver, an input port, a receiving circuit, or the like. The sending unit may be referred to as a transmitter machine, a transmitter, a transmission circuit, or the like.

It should be noted that the communication apparatus 1100 shown in FIG. 11 may be specifically configured to implement steps implemented by the transmit end or the receive end in the foregoing method embodiments, and implement technical effect corresponding to the transmit end or the receive end. For a specific implementation of the communication apparatus 1100 shown in FIG. 11, refer to descriptions in the foregoing method embodiments. Details are not described herein again.

An embodiment of this application further provides a computer-readable storage medium that stores one or more computer-executable instructions. When the computer-executable instructions are executed by a processor, the processor performs the method described in a possible implementation of the terminal device in the foregoing embodiments, namely, the transmit end in the foregoing method embodiments.

An embodiment of this application further provides a computer-readable storage medium that stores one or more computer-executable instructions. When the computer-executable instructions are executed by a processor, the processor performs the method described in a possible implementation of the network device in the foregoing embodiments, namely, the receive end in the foregoing method embodiments.

An embodiment of this application further provides a computer program product (or referred to as a computer program) that stores one or more computers. When the computer program product is executed by a processor, the processor performs the method in the foregoing possible implementations of the terminal device, namely, the transmit end in the foregoing method embodiments.

An embodiment of this application further provides a computer program product that stores one or more computers. When the computer program product is executed by a processor, the processor performs the method in the foregoing possible implementations of the network device, namely, the receive end in the foregoing method embodiments.

An embodiment of this application further provides a chip system. The chip system includes at least one processor, configured to support a first communication apparatus in implementing functions in the foregoing possible implementations of the first communication apparatus. Optionally, the chip system further includes an interface circuit, and the interface circuit provides program instructions and/or data for the at least one processor. In a possible design, the chip system may further include a memory. The memory is configured to store program instructions and data that are necessary for the first communication apparatus. The chip system may include a chip, or may include a chip and another discrete component. The first communication apparatus may be specifically the transmit end in the foregoing method embodiments.

An embodiment of this application further provides a chip system. The chip system includes at least one processor, configured to support a second communication apparatus in implementing functions in the foregoing possible implementations of the second communication apparatus. Optionally, the chip system further includes an interface circuit, and the interface circuit provides program instructions and/or data for the at least one processor. In a possible design, the chip system may further include a memory. The memory is configured to store program instructions and data that are necessary for the second communication apparatus. The chip system may include a chip, or may include a chip and another discrete component. The second communication apparatus may be specifically the receive end in the foregoing method embodiments.

An embodiment of this application further provides a communication system. The network system architecture includes the terminal device and the network device in any one of the foregoing embodiments, namely, the transmit end and the receive end in the foregoing method embodiments.

In the several embodiments provided in this application, it should be understood that the disclosed system, apparatus, and method may be implemented in other manners. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit. The integrated unit may be implemented in a form of hardware, or may be implemented in a form of a software functional unit. When the integrated unit is implemented in the form of the software functional unit and sold or used as an independent product, the integrated unit may be stored in a computer-readable storage medium. Based on such an understanding, the technical solutions of this application essentially, or the part contributing to the prior art, or all or some of the technical solutions may be implemented in the form of a software product. The computer software product is stored in a storage medium and includes several instructions for instructing a computer device (which may be a personal computer, a server, or a network device) to perform all or some of the steps of the methods described in embodiments of this application. The storage medium includes any medium that can store program code, such as a USB flash drive, a removable hard disk, a read-only memory (ROM, Read-Only Memory), a random access memory (RAM, Random Access Memory), a magnetic disk, or an optical disc.

**Claims**

1. A communication method, comprising:

    obtaining to-be-encoded information, wherein the to-be-encoded information comprises k bits, and k is a positive integer;
    determining that a quantity of code blocks is C, wherein C is a positive integer;
    performing polar encoding on the to-be-encoded information based on C, to obtain C encoded code blocks; and
    sending the C encoded code blocks.

2. The method according to claim 1, wherein the determining that a quantity of code blocks is C comprises:
    determining, based on k and a target bit rate, that the quantity of code blocks is C.

3. The method according to claim 2, wherein the target bit rate is one of at least two bit rates.

4. The method according to claim 2 or 3, wherein the target bit rate is 1/8, 1/4, or 1/2.

5. The method according to claim 4, wherein the determining, based on k and a target bit rate, that the quantity of code blocks is C comprises:

    when the target bit rate is 1/8 and k is less than a first threshold, determining that C is 1, or
    when the target bit rate is 1/8, k is greater than or equal to the first threshold, and k is less than a second threshold, determining that C is 2, or
    when the target bit rate is 1/8 and k is greater than or equal to the second threshold, determining that C is 3; or
    when the target bit rate is 1/4 and k is less than a third threshold, determining that C is 1, or
    when the target bit rate is 1/4, k is greater than or equal to the third threshold, and k is less than a fourth threshold, determining that C is 2, or
    when the target bit rate is 1/4 and k is greater than or equal to the fourth threshold, determining that C is 3; or
    when the target bit rate is 1/2 and k is less than a fifth threshold, determining that C is 1, or
    when the target bit rate is 1/2 and k is greater than or equal to the fifth threshold, determining that C is 2.

6. The method according to claim 5, wherein

    the first threshold is greater than or equal to 180 and the first threshold is less than or equal to 205; or
    the second threshold is greater than or equal to 310 and the second threshold is less than or equal to 355; or
    the third threshold is greater than or equal to 175, and the third threshold is less than or equal to 205; or
    the fourth threshold is greater than or equal to 310, and the fourth threshold is less than or equal to 335; or
    the fifth threshold is greater than or equal to 290, and the fifth threshold is less than or equal to 310.

7. The method according to any one of claims 1 to 6, wherein the performing polar encoding on the to-be-encoded information based on C, to obtain C encoded code blocks comprises:

    performing polar encoding on the to-be-encoded information based on C, to obtain C initial code blocks; and
    determining the C encoded code blocks based on the C initial code blocks, wherein an ith encoded code block in the C encoded code blocks is determined based on an ith initial code block in the C initial code blocks, and i is traversed from 1 to C.

8. The method according to claim 7, wherein that an $i^{th}$ encoded code block in the C encoded code blocks is determined based on an $i^{th}$ initial code block in the C initial code blocks comprises:

in at least one encoded code block in the C encoded code blocks, the $i^{th}$ encoded code block is the $i^{th}$ initial code block in the C initial code blocks; and
in encoded code blocks other than the at least one encoded code block in the C encoded code blocks, x bits in the $i^{th}$ encoded code block are a coupling result of x bits in the $i^{th}$ initial code block in the C initial code blocks and x bits in a $j^{th}$ initial code block, and remaining N-x bits in the $i^{th}$ encoded code block are remaining N-x bits in the $i^{th}$ initial code block in the C initial code blocks; and a quantity of the encoded code blocks is a positive integer, x is less than or equal to N, i is not equal to j, both i and j are less than or equal to C, and both i and j are positive integers.

9. The method according to claim 8, wherein x is equal to N/2.

10. The method according to claim 8 or 9, wherein the coupling result is an exclusive OR result.

11. The method according to any one of claims 8 to 10, wherein
i=j-1, or i=j+1.

12. The method according to any one of claims 1 to 11, wherein the sending the C encoded code blocks comprises:

storing a first part of encoded information of any code block in the C encoded code blocks into a first cyclic buffer, and storing a second part of the encoded information of the any code block in the C encoded code blocks into a second cyclic buffer;
reading bit information in the first cyclic buffer and bit information in the second cyclic buffer based on a target code length corresponding to the any code block in the C encoded code blocks, and using the bit information in the first cyclic buffer and the bit information in the second cyclic buffer as a target bit sequence; and
sending the target bit sequence.

13. The method according to claim 12, wherein

when the target code length corresponding to the any code block in the C encoded code blocks is less than or equal to a bit length corresponding to the any code block, the target bit sequence comprises a first sequence and a second sequence, wherein the first sequence comprises data obtained after puncturing processing is performed on data in the first cyclic buffer, and a sequence length of the first sequence is less than or equal to a sequence length of the first part; and the second sequence comprises data obtained after puncturing processing is performed on data in the second cyclic buffer, and a sequence length of the second sequence is less than or equal to a sequence length of the second part; or
when the target code length corresponding to the any code block in the C encoded code blocks is greater than a bit length corresponding to the any code block, the target bit sequence comprises one sequence, wherein the one sequence comprises data obtained after puncturing processing is performed on data in the first cyclic buffer and data obtained after puncturing processing is performed on data in the second cyclic buffer, and a sequence length of the sequence is greater than the bit length corresponding to the any code block.

14. The method according to claim 13, wherein

when a value of the target code length corresponding to the any code block in the C encoded code blocks is an even number, a quantity of bits corresponding to the any code block in the C encoded code blocks in the first cyclic buffer is the same as a quantity of bits corresponding to the any code block in the C code blocks in the second cyclic buffer; or
when a value of the target code length corresponding to the any code block in the C encoded code blocks is an odd number, a quantity of bits corresponding to the any code block in the C encoded code blocks in the second cyclic buffer is one more than a quantity of bits corresponding to the any code block in the C encoded code blocks in the first cyclic buffer.

15. The method according to any one of claims 12 to 14, wherein

a quantity of bits corresponding to the first part is half of a quantity of bits corresponding to the encoded information of the any code block in the C code blocks; and/or

a quantity of bits corresponding to the second part is half of a quantity of bits corresponding to the encoded information of the any code block in the C code blocks.

16. A communication method, comprising:

receiving first information, wherein the first information is obtained based on k pieces of bit information, and k is a positive integer;
determining that a quantity of code blocks corresponding to the first information is C, wherein C is a positive integer;
determining, based on C, C encoded code blocks corresponding to the first information; and
determining the k pieces of bit information based on the C encoded code blocks.

17. The method according to claim 16, wherein the determining that a quantity of code blocks corresponding to the first information is C comprises:
determining, based on k and a target bit rate, that the quantity of code blocks is C.

18. The method according to claim 16 or 17, wherein the determining the k pieces of bit information based on the C encoded code blocks comprises:

determining C initial code blocks based on the C encoded code blocks, wherein an $i^{th}$ initial code block in the C initial code blocks is determined based on an $i^{th}$ encoded code block in the C encoded code blocks, and i is traversed from 1 to C; and
performing decoding based on the C initial code blocks to obtain the k pieces of bit information.

19. The method according to any one of claims 16 to 18, wherein the determining, based on C, C encoded code blocks corresponding to the first information comprises:

determining a target bit sequence corresponding to the first information;
determining, based on a target code length corresponding to any code block in the C encoded code blocks, bit information of the target bit sequence in a first cyclic buffer and bit information of the target bit sequence in a second cyclic buffer;
determining a first part of encoded information of the any code block in the C encoded code blocks based on the bit information of the target bit sequence in the first cyclic buffer, and determining a second part of the encoded information of the any code block in the C encoded code blocks based on the bit information of the target bit sequence in the second cyclic buffer; and
determining the any code block in the C encoded code blocks based on the first part and the second part.

20. A communication apparatus, comprising a processing unit and a transceiver unit;

the processing unit is configured to obtain to-be-encoded information, wherein the to-be-encoded information comprises k bits, and k is a positive integer;
the processing unit is further configured to determine that a quantity of code blocks is C, wherein C is a positive integer;
the processing unit is further configured to perform polar encoding on the to-be-encoded information based on C, to obtain C encoded code blocks; and
the transceiver unit is configured to send the C encoded code blocks.

21. The apparatus according to claim 20, wherein the processing unit is specifically configured to determine, based on k and a target bit rate, that the quantity of code blocks is C.

22. The apparatus according to claim 21, wherein the target bit rate is one of at least two bit rates.

23. The apparatus according to claim 21 or 22, wherein the target bit rate is 1/8, 1/4, or 1/2.

24. The apparatus according to claim 23, wherein the processing unit is specifically configured to:

when the target bit rate is 1/8 and k is less than a first threshold, determine that C is 1, or
when the target bit rate is 1/8, k is greater than or equal to the first threshold, and k is less than a second threshold, determine that C is 2, or
when the target bit rate is 1/8 and k is greater than or equal to the second threshold, determine that C is 3; or
when the target bit rate is 1/4 and k is less than a third threshold, determine that C is 1, or
when the target bit rate is 1/4, k is greater than or equal to the third threshold, and k is less than a fourth threshold, determine that C is 2, or
when the target bit rate is 1/4 and k is greater than or equal to the fourth threshold, determine that C is 3; or
when the target bit rate is 1/2 and k is less than a fifth threshold, determine that C is 1, or
when the target bit rate is 1/2 and k is greater than or equal to the fifth threshold, determine that C is 2.

25. The apparatus according to claim 24, wherein

the first threshold is greater than or equal to 180 and the first threshold is less than or equal to 205; or
the second threshold is greater than or equal to 310 and the second threshold is less than or equal to 355; or
the third threshold is greater than or equal to 175, and the third threshold is less than or equal to 205; or
the fourth threshold is greater than or equal to 310, and the fourth threshold is less than or equal to 335; or
the fifth threshold is greater than or equal to 290, and the fifth threshold is less than or equal to 310.

26. The apparatus according to any one of claims 20 to 25, wherein the processing unit is specifically configured to:

perform polar encoding on the to-be-encoded information based on C, to obtain C initial code blocks; and
determine the C encoded code blocks based on the C initial code blocks, wherein an $i^{th}$ encoded code block in the C encoded code blocks is determined based on an $i^{th}$ initial code block in the C initial code blocks, and i is traversed from 1 to C.

27. The apparatus according to claim 26, wherein that an $i^{th}$ encoded code block in the C encoded code blocks is determined based on an $i^{th}$ initial code block in the C initial code blocks comprises:

in at least one encoded code block in the C encoded code blocks, the $i^{th}$ encoded code block is the $i^{th}$ initial code block in the C initial code blocks; and
in encoded code blocks other than the at least one encoded code block in the C encoded code blocks, x bits in the $i^{th}$ encoded code block are a coupling result of x bits in the $i^{th}$ initial code block in the C initial code blocks and x bits in a $j^{th}$ initial code block, and remaining N-x bits in the $i^{th}$ encoded code block are remaining N-x bits in the $i^{th}$ initial code block in the C initial code blocks; and a quantity of the encoded code blocks is a positive integer, x is less than or equal to N, i is not equal to j, both i and j are less than or equal to C, and both i and j are positive integers.

28. The apparatus according to claim 27, wherein x is equal to N/2.

29. The apparatus according to claim 27 or 28, wherein the coupling result is an exclusive OR result.

30. The apparatus according to any one of claims 27 to 29, wherein
i=j-1, or i=j+1.

31. The apparatus according to any one of claims 20 to 30, wherein the transceiver unit is specifically configured to:

store a first part of encoded information of any code block in the C encoded code blocks into a first cyclic buffer, and store a second part of the encoded information of the any code block in the C encoded code blocks into a second cyclic buffer;
read bit information in the first cyclic buffer and bit information in the second cyclic buffer based on a target code length corresponding to the any code block in the C encoded code blocks, and use the bit information in the first cyclic buffer and the bit information in the second cyclic buffer as a target bit sequence; and
send the target bit sequence.

32. The apparatus according to claim 31, wherein

when the target code length corresponding to the any code block in the C encoded code blocks is less than or equal to a bit length corresponding to the any code block, the target bit sequence comprises a first sequence and a second sequence, wherein the first sequence comprises data obtained after puncturing processing is performed on data in the first cyclic buffer, and a sequence length of the first sequence is less than or equal to a sequence length of the first part; and the second sequence comprises data obtained after puncturing processing is performed on data in the second cyclic buffer, and a sequence length of the second sequence is less than or equal to a sequence length of the second part; or

when the target code length corresponding to the any code block in the C encoded code blocks is greater than a bit length corresponding to the any code block, the target bit sequence comprises one sequence, wherein the one sequence comprises data obtained after puncturing processing is performed on data in the first cyclic buffer and data obtained after puncturing processing is performed on data in the second cyclic buffer, and a sequence length of the sequence is greater than the bit length corresponding to the any code block.

**33.** The apparatus according to claim 32, wherein

when a value of the target code length corresponding to the any code block in the C encoded code blocks is an even number, a quantity of bits corresponding to the any code block in the C encoded code blocks in the first cyclic buffer is the same as a quantity of bits corresponding to the any code block in the C code blocks in the second cyclic buffer; or

when a value of the target code length corresponding to the any code block in the C encoded code blocks is an odd number, a quantity of bits corresponding to the any code block in the C encoded code blocks in the second cyclic buffer is one more than a quantity of bits corresponding to the any code block in the C encoded code blocks in the first cyclic buffer.

**34.** The apparatus according to any one of claims 31 to 33, wherein

a quantity of bits corresponding to the first part is half of a quantity of bits corresponding to the encoded information of the any code block in the C code blocks; and/or

a quantity of bits corresponding to the second part is half of a quantity of bits corresponding to the encoded information of the any code block in the C code blocks.

**35.** A communication apparatus, comprising a transceiver unit and a processing unit;

the transceiver unit is configured to receive first information, wherein the first information is obtained based on k pieces of bit information, and k is a positive integer;

the processing unit is configured to determine that a quantity of code blocks corresponding to the first information is C, wherein C is a positive integer;

the processing unit is further configured to determine, based on C, C encoded code blocks corresponding to the first information; and

the processing unit is further configured to determine the k pieces of bit information based on the C encoded code blocks.

**36.** The apparatus according to claim 35, wherein the processing unit is specifically configured to:
determine, based on k and a target bit rate, that the quantity of code blocks is C.

**37.** The apparatus according to claim 35 or 36, wherein the processing unit is specifically configured to:

determine C initial code blocks based on the C encoded code blocks, wherein an $i^{th}$ initial code block in the C initial code blocks is determined based on an $i^{th}$ encoded code block in the C encoded code blocks, and i is traversed from 1 to C; and

perform decoding based on the C initial code blocks to obtain the k pieces of bit information.

**38.** The apparatus according to any one of claims 35 to 37, wherein the processing unit is specifically configured to:

determine a target bit sequence corresponding to the first information;

determine, based on a target code length corresponding to any code block in the C encoded code blocks, bit information of the target bit sequence in a first cyclic buffer and bit information of the target bit sequence in a second cyclic buffer;

determine a first part of encoded information of the any code block in the C encoded code blocks based on the bit information of the target bit sequence in the first cyclic buffer, and determining a second part of the encoded information of the any code block in the C encoded code blocks based on the bit information of the target bit sequence in the second cyclic buffer; and

determine the any code block in the C encoded code blocks based on the first part and the second part.

39. A communication apparatus, wherein the communication apparatus comprises at least one processor, and the at least one processor is coupled to a memory;

the memory is configured to store a program and/or instructions; and
the at least one processor is configured to: based on the program and/or the instructions, enable the communication apparatus to perform the method according to any one of claims 1 to 15, or enable the communication apparatus to perform the method according to any one of claims 16 to 19.

40. A communication system, wherein the communication system comprises at least one transmit end and at least one receive end; and
the at least one transmit end is configured to implement the method according to any one of claims 1 to 15, and the at least one receive end is configured to implement the method according to any one of claims 16 to 19.

41. A computer-readable storage medium, wherein the medium stores instructions, and when the instructions are executed by a computer, the method according to any one of claims 1 to 19 is implemented.

42. A computer program product, comprising instructions, wherein when the instructions are run on a computer, the computer is enabled to perform the method according to any one of claims 1 to 19.

Network device

Terminal
device 5

Terminal
device 1

Terminal
device 2

Terminal
device 3

Terminal
device 4

Terminal
device 6

FIG. 1

```
┌─────────────────┐                              ┌─────────────────┐
│  Transmit end   │                              │   Receive end   │
└────────┬────────┘                              └────────┬────────┘
         │                                                │
┌────────┴──────────────────────┐                         │
│ S201: Obtain to-be-encoded    │                         │
│       information             │                         │
└────────┬──────────────────────┘                         │
         │                                                │
┌────────┴──────────────────────┐                         │
│ S202: Determine that a        │                         │
│ quantity of code blocks is C  │                         │
└────────┬──────────────────────┘                         │
         │                                                │
┌────────┴──────────────────────┐                         │
│ S203: Perform polar encoding  │                         │
│ on the to-be-encoded          │                         │
│ information based on C, to     │                         │
│ obtain C encoded code blocks  │                         │
└────────┬──────────────────────┘                         │
         │    S204: Send the C          ┌────────────────┴──────────────┐
         ├──  encoded code blocks  ───► │ S204: Receive first           │
         │                              │       information             │
         │                              └────────────────┬──────────────┘
         │                              ┌────────────────┴──────────────┐
         │                              │ S205: Determine that a        │
         │                              │ quantity of code blocks       │
         │                              │ corresponding to the first    │
         │                              │ information is C              │
         │                              └────────────────┬──────────────┘
         │                              ┌────────────────┴──────────────┐
         │                              │ S206: Determine, based on C,  │
         │                              │ the C encoded code blocks     │
         │                              │ corresponding to the first    │
         │                              │ information                   │
         │                              └────────────────┬──────────────┘
         │                              ┌────────────────┴──────────────┐
         │                              │ S207: Determine k pieces of   │
         │                              │ bit information based on the  │
         │                              │ C encoded code blocks         │
         │                              └────────────────┬──────────────┘
         │                                                │
```

FIG. 2

FIG. 3

FIG. 4

FIG. 5a

FIG. 5b

FIG. 6a

E≥N--repetition          R=K/E≤7/16--puncture          R=K/E>7/16--shorten

FIG. 6b

FIG. 6c

Transmit end

| Source | → | Source encoding | → | Channel encoding | → | Modulation |

Receive end

| Sink | ← | Source restoration | ← | Channel decoding | ← | Demodulation |

FIG. 7

800

Communication apparatus

801

Processing unit

802

Transceiver unit

FIG. 8

900

Communication apparatus

901

Logic circuit

902

Input/Output interface

FIG. 9

1000

Communication apparatus

1002

Communication port

1001

Processor

1004

1003

Memory

FIG. 10

1115

1113

Tx

Processor

1111

1112

Rx

Memory

Network interface

1114

FIG. 11

## INTERNATIONAL SEARCH REPORT

<table>
<tr><td>International application No.</td></tr>
<tr><td>**PCT/CN2022/103274**</td></tr>
</table>

### A. CLASSIFICATION OF SUBJECT MATTER

H04L 1/00(2006.01)i; H03M 13/13(2006.01)i; H03M 13/09(2006.01)i

According to International Patent Classification (IPC) or to both national classification and IPC

### B. FIELDS SEARCHED

Minimum documentation searched (classification system followed by classification symbols)

H04L; H03M

Documentation searched other than minimum documentation to the extent that such documents are included in the fields searched

Electronic data base consulted during the international search (name of data base and, where practicable, search terms used)

CNTXT; VEN; ENTXTC; CNKI; 3GPP; IEEE: 编码, 解码, 译码, 码块, 数量, 个数, 数目, 总数, 极化码, 码率, 码长, 耦合, 循环, 缓存, encode, decode, code block, number, count, quantity, amount, total, Polar, code rate, code length, couple, ring, circle, buffer

### C. DOCUMENTS CONSIDERED TO BE RELEVANT

| Category* | Citation of document, with indication, where appropriate, of the relevant passages | Relevant to claim No. |
|---|---|---|
| X | CN 108289010 A (ZTE CORP.) 17 July 2018 (2018-07-17)<br>claims 1-37, description, paragraphs [0001]-[0465], and figures 1-9 | 1-42 |
| X | CN 112019298 A (HUAWEI TECHNOLOGIES CO., LTD.) 01 December 2020 (2020-12-01)<br>description, paragraphs [0001]-[0345], and figures 1-18 | 1-42 |
| A | CN 107342773 A (HUAWEI TECHNOLOGIES CO., LTD.) 10 November 2017 (2017-11-10)<br>entire document | 1-42 |
| A | CN 109842458 A (CHINA ACADEMY OF TELECOMMUNICATIONS TECHNOLOGY)<br>04 June 2019 (2019-06-04)<br>entire document | 1-42 |
| A | US 2020304231 A1 (QUALCOMM INC.) 24 September 2020 (2020-09-24)<br>entire document | 1-42 |

☐ Further documents are listed in the continuation of Box C.    ☑ See patent family annex.

| | |
|---|---|
| *   Special categories of cited documents:<br>"A"   document defining the general state of the art which is not considered to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
|---|---|
| **05 December 2022** | **14 December 2022** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2022/103274**

| Patent document cited in search report | | | Publication date (day/month/year) | Patent family member(s) | | | Publication date (day/month/year) |
|---|---|---|---|---|---|---|---|
| CN | 108289010 | A | 17 July 2018 | US | 2020099399 | A1 | 26 March 2020 |
| | | | | EP | 3567732 | A1 | 13 November 2019 |
| CN | 112019298 | A | 01 December 2020 | None | | | |
| CN | 107342773 | A | 10 November 2017 | JP | 2019534656 | A | 28 November 2019 |
| | | | | US | 2018367251 | A1 | 20 December 2018 |
| | | | | US | 2019349129 | A1 | 14 November 2019 |
| | | | | BR | 112019008296 | A2 | 17 September 2019 |
| | | | | CN | 108649965 | A | 12 October 2018 |
| | | | | ES | 2923885 | T3 | 03 October 2022 |
| | | | | CA | 3041571 | A1 | 03 May 2018 |
| | | | | RU | 2720644 | C1 | 12 May 2020 |
| | | | | EP | 3419178 | A1 | 26 December 2018 |
| | | | | KR | 20190066065 | A | 12 June 2019 |
| | | | | CN | 108631789 | A | 09 October 2018 |
| | | | | AU | 2017352158 | A1 | 23 May 2019 |
| | | | | WO | 2018076944 | A1 | 03 May 2018 |
| CN | 109842458 | A | 04 June 2019 | WO | 2019100795 | A1 | 31 May 2019 |
| | | | | KR | 20200090877 | A | 29 July 2020 |
| | | | | US | 2020389249 | A1 | 10 December 2020 |
| | | | | EP | 3716509 | A1 | 30 September 2020 |
| | | | | JP | 2021505028 | A | 15 February 2021 |
| US | 2020304231 | A1 | 24 September 2020 | WO | 2020197749 | A1 | 01 October 2020 |

Form PCT/ISA/210 (patent family annex) (January 2015)